# EUROPEAN PATENT APPLICATION

(11) **EP 4 391 766 A1**
(43) Date of publication of application: **26.06.2024**
(21) Application number: 22866963.6
(22) Date of filing: 25.03.2022
(51) Int. Cl.: H10K 50/00

(54) **LIGHT-EMITTING ELEMENT ARRAY, LIGHT-EMITTING DEVICE, ELECTRONIC APPARATUS, AND PHOTONIC CRYSTAL STRUCTURE**

(30) Priority: 09.09.2021 JP 2021146988
(71) Applicant: Sony Semiconductor Solutions Corporation, Atsugi-shi, Kanagawa 243-0014 (JP); Sony Group Corporation, Tokyo 108-0075 (JP)
(72) Inventor: TOMODA, Katsuhiro, Atsugi-shi, Kanagawa 243-0014 (JP); UEDA, Kazuya, Atsugi-shi, Kanagawa 243-0014 (JP); YASUDA, Atsushi, Atsugi-shi, Kanagawa 243-0014 (JP); BIWA, Goshi, Tokyo 108-0075 (JP); NAITO, Hiroki, Atsugi-shi, Kanagawa 243-0014 (JP); NISHINAKA, Ippei, Tokyo 108-0075 (JP); OHMAE, Akira, Tokyo 108-0075 (JP)
(74) Representative: D Young & Co LLP
(86) International application number: PCT/JP2022/014291
(87) International publication number: WO 2023/037631

(57) **Abstract**

Provided are a light emitting element array, a light emitting device, an electronic device, and a photonic crystal structure which are improved in stray light suppression, high luminance, and low power consumption.

A light emitting element array includes a plurality of a light emitting element including a light emitting surface, in which a plurality of a light emitting unit is formed including at least one of the light emitting element and capable of controlling light emission from the light emitting surface of the light emitting element, and the plurality of the light emitting unit is provided with an optical adjustment layer at least partially including a periodic structure portion in which a refractive index periodically changes.

## Description

### TECHNICAL FIELD

The present disclosure relates to a light emitting element array, a light emitting device, an electronic device, and a photonic crystal structure.

### BACKGROUND ART

Light emitting devices using light emitting element arrays such as semiconductor light emitting element arrays are expected to be applied to various fields such as augmented reality (AR), virtual reality (VR), and mixed reality (MR) along with miniaturization and high definition. In a light emitting element array, suppression of a state in which light generated in a light emitting unit as a pixel or the like propagates to an adjacent light emitting unit, that is, suppression of stray light is desired, and further, high luminance and low power consumption are desired.

For example, the technique of Patent Document 1 proposes a device including a structure including a light emitting region disposed between an n-type region and a p-type region, and a reflector on at least a part of a lower surface of the structure. For this device, a plurality of holes is formed in the structure in a first region of the structure corresponding to a first portion of the light emitting region. The plurality of second regions of the structure corresponding to the second portion of the light emitting region has no holes, and each of the second regions corresponds to the second portion of the light emitting region and is surrounded by the first region. The device is also configured such that when forward biased, current is injected into the second region and there is no current in the first region.

### CITATION LIST

### PATENT DOCUMENT

Patent Document 1: Japanese Patent Application Laid-Open No. 2003-163368

### SUMMARY OF THE INVENTION

### PROBLEMS TO BE SOLVED BY THE INVENTION

The technique of Patent Document 1 has room for further improvement in terms of suppression of the above-described stray light, high luminance, and low power consumption.

The present disclosure has been made in view of the above-described points, and an object of the present disclosure is to provide a light emitting element array, a light emitting device, an electronic device, and a photonic crystal structure that are improved in stray light suppression, high luminance, and low power consumption.

### SOLUTIONS TO PROBLEMS

The present disclosure is, for example, (1) a light emitting element array including
a plurality of a light emitting element including a light emitting surface,
in which a plurality of a light emitting unit (pixel) is formed including at least one of the light emitting element and capable of controlling light emission from the light emitting surface of the light emitting element, and
the plurality of the light emitting unit is provided with an optical adjustment layer at least partially including a periodic structure portion in which a refractive index periodically changes.

In addition, the present disclosure is (2) a photonic crystal structure used in a light emitting device, and
including a photonic crystal portion in which a refractive index periodically changes at least along a plane direction in at least a part.

The present disclosure is (3) a light emitting device using the light emitting element array according to (1).

The present disclosure is (4) an electronic device using the light emitting element array according to (1).

### BRIEF DESCRIPTION OF DRAWINGS

Fig. 1 is a cross-sectional view illustrating a schematic configuration of an example of a light emitting element array according to the first embodiment.
Fig. 2A is a plan view schematically illustrating an example of a schematic configuration of an example of the light emitting element array according to the first embodiment. Fig. 2B is a cross-sectional view schematically illustrating a state of a longitudinal cross section taken along line IIB-IIB in Fig. 2A. Fig. 2C is a plan view schematically illustrating a state in which a portion of region XS1 indicated by a broken line in Fig. 2A is enlarged.
Fig. 3 is a cross-sectional view schematically illustrating a schematic configuration of an example of the light emitting element array according to the first embodiment.
Fig. 4A is a plan view for explaining an example of a light emitting element array according to Modification 1 of the first embodiment. Fig. 4B is a cross-sectional view schematically illustrating a state of a longitudinal cross section taken along line IVB-IVB in Fig. 4A.
Fig. 5A is a cross-sectional view for explaining an example of a light emitting element array according to Modification 3 of the first embodiment. Fig. 5B is a cross-sectional view for explaining an example of a light emitting element array according to Modification 5 of the first embodiment.
Fig. 6A is a plan view schematically illustrating an example of a schematic configuration of an example of a light emitting element array according to Modification 6 of the first embodiment. Fig. 6B is a cross-sectional view schematically illustrating a state of a longitudinal cross section taken along line VIB-VIB in Fig. 6A. Fig. 6C is a plan view schematically illustrating a state in which a portion of region XS2 indicated by a broken line in Fig. 6A is enlarged.
Fig. 7A is a plan view schematically illustrating an example of a schematic configuration of an example of a light emitting element array according to Modification 7 of the first embodiment. Fig. 7B is a cross-sectional view schematically illustrating a state of a longitudinal cross section taken along line VIIB-VIIB of Fig. 7A.
Fig. 7C is a plan view schematically illustrating a state in which a portion of region XS3 indicated by a broken line in Fig. 7A is enlarged.
Fig. 8A is a plan view schematically illustrating an example of a schematic configuration of an example of a light emitting element array according to Modification 8 of the first embodiment. Fig. 8B is a cross-sectional view schematically illustrating a state of a longitudinal cross section taken along line VIIIB-VIIIB in Fig. 8A.
Figs. 9A and 9B are cross-sectional views for explaining an example of a light emitting element array according to Modification 9 of the first embodiment.
Fig. 10A is a cross-sectional view for explaining an example of a light emitting element array according to Modification 10 of the first embodiment.
Fig. 10B is a cross-sectional view for explaining an example of a light emitting element array according to Modification 11 of the first embodiment.
Fig. 11 is a cross-sectional view for explaining an example of a light emitting element array according to Modification 12 of the first embodiment.
Fig. 12 is a cross-sectional view for explaining an example of a light emitting element array according to the second embodiment.
Fig. 13 is a cross-sectional view for explaining an example of a light emitting element array according to the third embodiment.
Fig. 14 is a cross-sectional view for explaining an example of a light emitting element array according to the fourth embodiment.
Fig. 15 is a cross-sectional view for explaining an example of a light emitting element array according to the fifth embodiment.
Fig. 16 is a diagram for explaining an example of an electronic device using a light emitting element array.

### MODE FOR CARRYING OUT THE INVENTION

Hereinafter, an example and the like according to the present disclosure will be described with reference to the drawings. Note that, the description will be made in the following order. In the present specification and the drawings, configurations having substantially the same functional configuration are denoted by the same reference signs, and redundant descriptions are omitted.

Note that the description will be given in the following order.
1. First Embodiment
2. Second Embodiment
3. Third Embodiment
4. Fourth Embodiment
5. Fifth Embodiment
6. Application Example

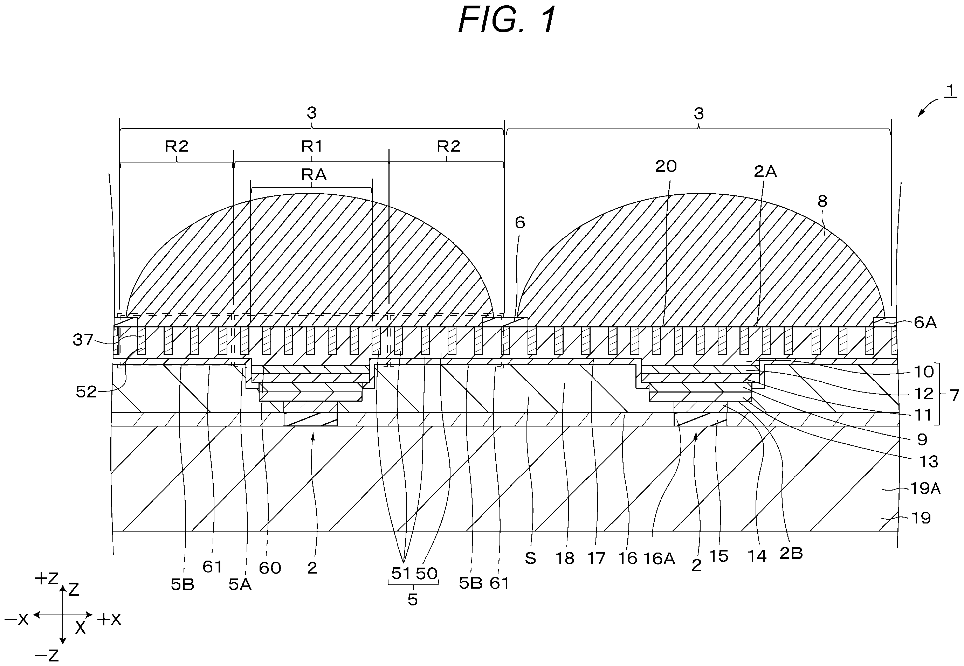

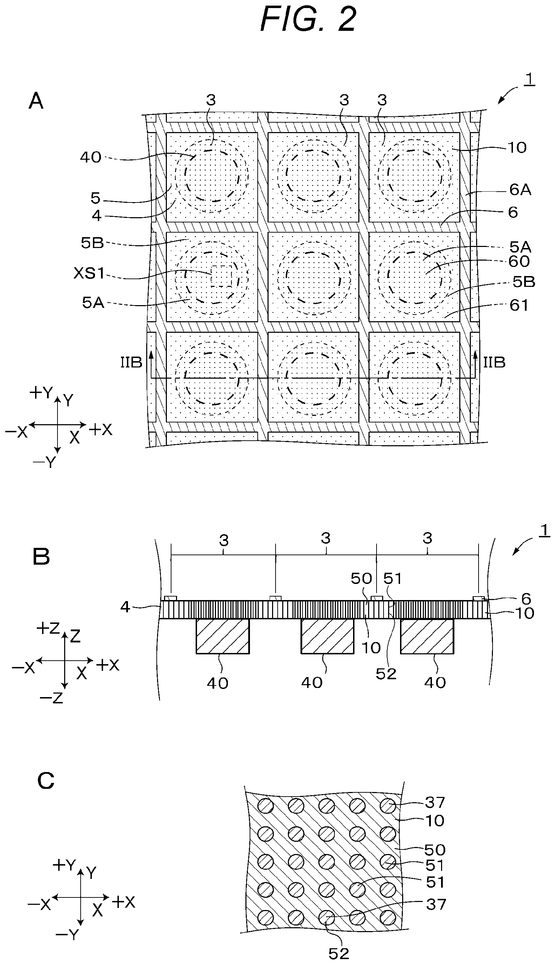

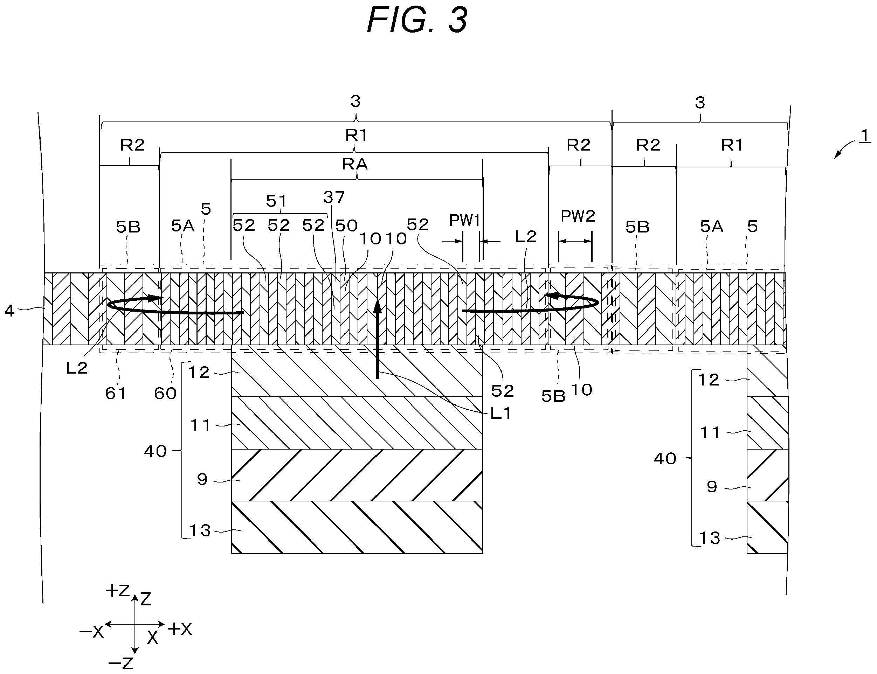

The following description is preferred specific examples of the present disclosure, and the content of the present disclosure is not limited to these embodiments and the like. Furthermore, in the following description, directions of front and back, left and right, up and down, and the like are indicated in consideration of convenience of description, but the content of the present disclosure is not limited to these directions. In examples of Figs. 1, 2A, 2B, 2, and the like, it is assumed that the Z-axis direction is the up-down direction (upper side is in a +Z direction, and lower side is in a -Z direction), the X-axis direction is the front-back direction (front side is in a +X direction, and back side is in a -X direction), and the Y-axis direction is the left-right direction (right side is in a +Y direction, and left side is in a -Y direction), and the description will be made on the basis of this. This similarly applies to Figs. 3 to 15. A relative magnitude ratio of the size and thickness of each layer illustrated in each drawing of Fig. 1 and the like is described for convenience, and do not limit actual magnitude ratios. This similarly applies to each drawing of Figs. 2 to 15 regarding the definition and the magnitude ratio regarding these directions.

In the light emitting element array according to the present disclosure, the type of the light emitting element is not particularly limited, and an organic light emitting diode (OLED) (organic EL light emitting element), a light emitting diode (LED) (semiconductor light emitting element), and the like can be exemplified. In addition, among the OLEDs and the LEDs, so-called micro OLEDs and micro LEDs that are more miniaturized may be adopted as the light emitting element.

The following first to fifth embodiments will be described by taking a case where the light emitting element array is a semiconductor light emitting element array as an example. The first to fifth embodiments may also be applied to a case where the light emitting element is other than the semiconductor light emitting element.

### [1 First Embodiment]

### [1-1 Configuration of Light Emitting Element Array]

As illustrated in Figs. 1, 2A, 2B, 2C, and 3, a semiconductor light emitting element array (hereinafter, simply referred to as a light emitting element array 1) according to a first embodiment includes a plurality of semiconductor light emitting elements 2 having a light emitting surface 20 as a plurality of light emitting elements having a light emitting surface. In addition, a plurality of light emitting units 3 is formed in the light emitting element array 1. Then, the plurality of light emitting units 3 is provided with an optical adjustment layer 4. Note that Fig. 1 is a cross-sectional view schematically illustrating the light emitting element array 1 according to the first embodiment. Fig. 2A is a plan view schematically illustrating the light emitting element array 1 according to the first embodiment. Fig. 2B is a cross-sectional view for explaining a state of a longitudinal cross section taken along line A-A in Fig. 1A. In addition, Fig. 3 is a schematic cross-sectional view for explaining traveling of light generated in the light emitting element array 1 according to the first embodiment. However, Fig. 3 is a diagram for schematic description, and does not limit the state of each layer such as the state of a light emitting layer 12 and the optical adjustment layer 4 or the laminated state of each layer.

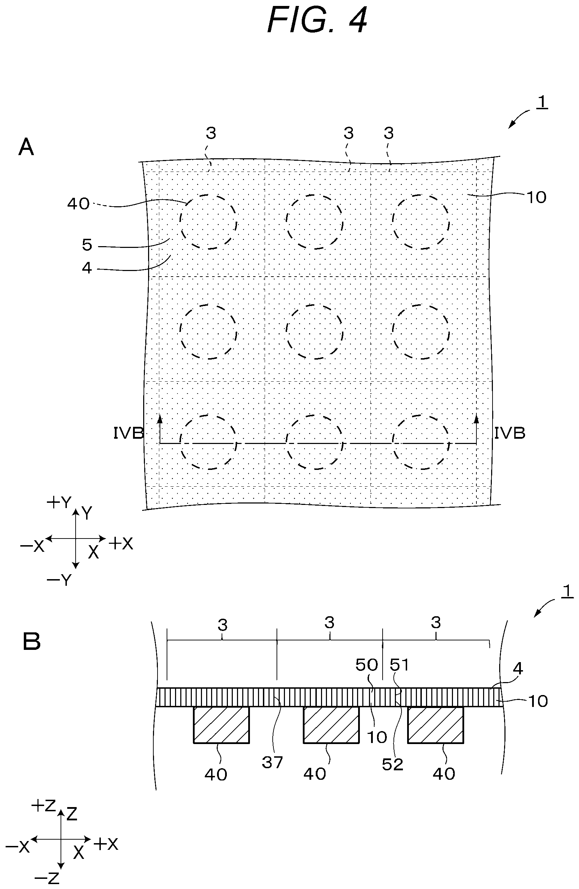

Note that, in Fig. 2B, reference sign 40 denotes a portion of the semiconductor light emitting element 2 where the light emitting layer 12, a second compound semiconductor layer 11, a contact electrode 9, and a reflective metal layer 13 are combined (a layer structure portion between the optical adjustment layer 4 and a light emitting element-side bump 14). This similarly applies to Figs. 3 to 11. In the examples of Figs. 2A, 2B, and 3, in plan view of the light emitting element array 1, the region where the portion 40 of the semiconductor light emitting element 2 is disposed corresponds to the arrangement region RA of the light emitting layer 12 of the semiconductor light emitting element 2, and generally corresponds to the light emitting region of the semiconductor light emitting element 2. This similarly applies to Figs. 4 to 11.

Hereinafter, among the main surfaces (2A and 2B) of the semiconductor light emitting element 2, a surface facing the light emitting surface 20 side of the semiconductor light emitting element 2 (a surface facing in the +Z direction) is assumed to be a first main surface (a first main surface 2A of the semiconductor light emitting element 2), and a surface facing opposite to the first main surface in the thickness direction (Z-axis direction) of the semiconductor light emitting element 2 (a surface facing in the -Z direction) is assumed to be a second main surface (a second main surface 2B of the semiconductor light emitting element 2). The first main surface and the second main surface are defined in a similar manner for each layer (for example, the light emitting layer 12 or the like) constituting the semiconductor light emitting element 2. It similarly applies to the second to fifth embodiments.

### (Light Emitting Unit)

The light emitting element array 1 forms a plurality of light emitting units 3. The light emitting unit 3 is defined as a portion having at least one semiconductor light emitting element 2 in the light emitting element array 1. In the light emitting element array 1, the light emitting unit 3 is configured to be able to control light emission from the light emitting surface 20 of the semiconductor light emitting element 2. In the example of Figs. 1, 2, and the like, the light emitting unit 3 is specified as a predetermined portion including one semiconductor light emitting element 2.

In the light emitting element array 1, as illustrated in Fig. 2A, a plurality of light emitting units 3 is formed in a predetermined layout in plan view of the light emitting element array 1. As illustrated in the example of Fig. 2A, the plurality of light emitting units 3 is two-dimensionally arranged in a matrix shape. In addition, in Fig. 2A, the direction in which the light emitting units 3 are arranged is along the X-axis direction and the Y-axis direction. Note that the layout of the light emitting units illustrated in Fig. 2A is an example, and the layout of the light emitting units is not limited to the example of Fig. 2A. Fig. 2A is a plan view for schematically explaining a state in a case where an example of the light emitting element array according to the first embodiment illustrated in Fig. 1 is viewed in a plan view. As described later in Modification 12, sub light emitting units 30 may be arranged in a delta shape, and the light emitting units 3 configured by a combination of the sub light emitting units 30 may also be arranged in a delta shape. The fact that the sub light emitting units 30 are arranged in a delta shape indicates that the center of the sub light emitting unit 30 is located at the vertex of a triangle.

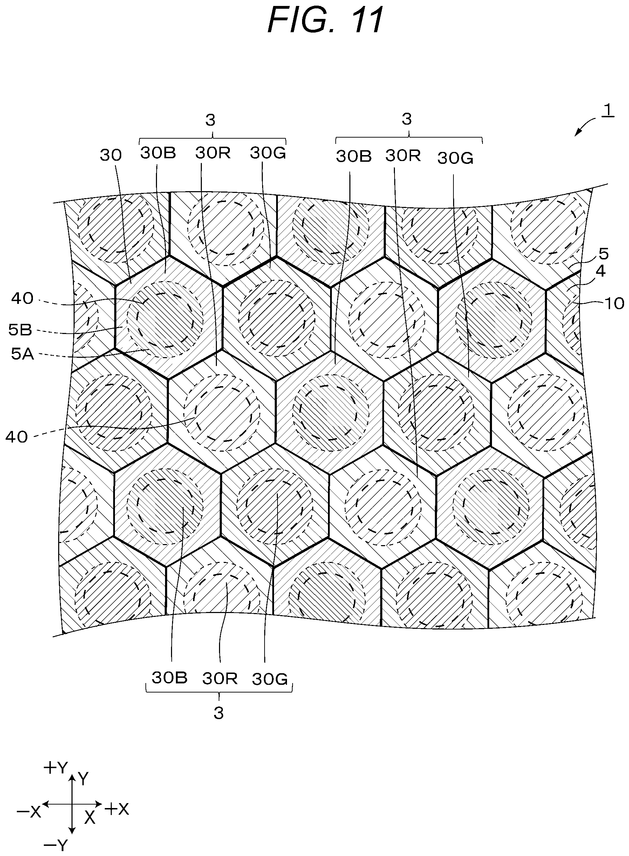

In Figs. 2A and 2B, for convenience of description, description of a lens 8, a first insulating layer 17, a second insulating layer 18, the light emitting element-side bump 14, a substrate-side bump 15, a substrate-side insulating layer 16, and a drive substrate 19, which will be described later, and detailed description of each layer constituting the semiconductor light emitting element 2 are omitted. In addition, in Fig. 2A, the configuration of a unit structure portion 52 of a second refractive index portion 51 described later is illustrated in dots. In Fig. 2B, the configuration of the unit structure portion 52 is described in a linear form. The description of these dots or the linear form of the unit structure portion 52 are similar to Figs. 3 to 10. Note that, in Fig. 11, description of the unit structure portion 52 is omitted, and each region of the first portion 5A and the second portion 5B is indicated by hatching.

In a case where the light emitting element array 1 is used in a display device or the like, each of the light emitting units 3 can correspond to a pixel of the display device. Furthermore, in a case where the pixel is constituted by a plurality of subpixels, the sub light emitting unit 30 described later can be made to correspond to each subpixel.

The light emitted by the light emitting unit 3 is not particularly limited, and is, for example, red, blue, green, near infrared, infrared, near ultraviolet, or ultraviolet.

### (Semiconductor Light Emitting Element)

In the light emitting element array 1 illustrated in the example of Fig. 1, one semiconductor light emitting element 2 is provided for one light emitting unit 3.

As the semiconductor light emitting element 2, a micro LED (Light Emitting Diode) or the like can be exemplified as described above. In the micro LED, the light emitting layer 12 of a laminated structure 7 described above is formed with a very fine dimension such as a dimension of micrometers or less. Since the semiconductor light emitting element 2 is a micro LED, downsizing of the light emitting element array 1 can be improved.

In the example of Fig. 1, the semiconductor light emitting element 2 includes a compound semiconductor laminated structure (hereinafter, referred to as the laminated structure 7) and electrodes (an auxiliary electrode (not illustrated) and the contact electrode 9).

### (Laminated Structure)

The laminated structure 7 includes a plurality of laminated compound semiconductor layers. Specifically, the laminated structure 7 includes a first compound semiconductor layer 10, the second compound semiconductor layer 11, and the light emitting layer 12. The laminated structure 7 has a structure in which the light emitting layer 12 is a core layer, and the first compound semiconductor layer 10 and the second compound semiconductor layer 11 are cladding layers sandwiching the core layer. In the example of Fig. 1, the first compound semiconductor layer 10 is a cladding layer closer to the light emitting surface 20 of the semiconductor light emitting element 2, and the second compound semiconductor layer 11 is a cladding layer farther from the light emitting surface 20. The light emitting layer 12 is provided between the first compound semiconductor layer 10 and the second compound semiconductor layer 11. However, the configuration of the laminated structure 7 is not limited thereto, and a laminated structure other than the above may be provided.

The first compound semiconductor layer 10 has a first conductivity type, and the second compound semiconductor layer 11 has a second conductivity type opposite to the first conductivity type. Specifically, for example, the first compound semiconductor layer 10 has an n-type, and the second compound semiconductor layer 11 has a p-type.

The first compound semiconductor layer 10 and the second compound semiconductor layer 11 include a compound semiconductor. The compound semiconductor is, for example, a GaN-based compound semiconductor (AlGaN mixed crystal, AlInGaN mixed crystal, or InGaN mixed crystal), an InN-based compound semiconductor, an InP-based compound semiconductor, an AlN-based compound semiconductor, a GaAs-based compound semiconductor, an AlGaAs-based compound semiconductor, an AlGaInP-based compound semiconductor, an AlGaInAs-based compound semiconductor, an AlAs-based compound semiconductor, a GaInAs-based compound semiconductor, a GaInAsP-based compound semiconductor, a GaP-based compound semiconductor, or a GaInP-based compound semiconductor.

Among these compounds, n-type GaN or n-type AlGaInP (which may be described as n-GaN and n-AlGaInP, respectively) is suitably used for the first compound semiconductor layer 10. In addition, it is not denied that the above-described first compound semiconductor layer 10 has p-type and the second compound semiconductor layer 11 has n-type. In this case, p-type AlGaInP (sometimes described as p-AlGaInP) is suitably used for the first compound semiconductor layer 10. Therefore, the first compound semiconductor layer 10 may be specifically a compound semiconductor layer containing at least one selected from the group including n-GaN, n-AlGaInP, and p-AlGaInP.

In a case where the first compound semiconductor layer 10 has n-type and the second compound semiconductor layer 11 has p-type, the n-type impurity added to the first compound semiconductor layer 10 is, for example, silicon (Si), selenium (Se), germanium (Ge), tin (Sn), carbon (C), or titanium (Ti). The p-type impurity added to the second compound semiconductor layer 11 is zinc (Zn), magnesium (Mg), beryllium (Be), cadmium (Cd), calcium (Ca), barium (Ba), or oxygen (O).

The light emitting layer 12 contains a compound semiconductor. Examples of the compound semiconductor can include materials similar to those of the first compound semiconductor layer 10 and the second compound semiconductor layer 11. The light emitting layer 12 may be configured by a single compound semiconductor layer, or may have a single quantum well structure (SQW structure) or a multi quantum well structure (MQW structure).

In the laminated structure 7, the light emitting layer 12 and the second compound semiconductor layer 11 are layers formed in a separated state for each semiconductor light emitting element 2 (layers independent for each light emitting unit 3), and the first compound semiconductor layer 10 is a layer common to the plurality of semiconductor light emitting elements 2 (layers common to the plurality of light emitting units 3) .

The semiconductor light emitting element 2 may be any of a red semiconductor light emitting element that generates red light, a green semiconductor light emitting element that generates green light, and a blue semiconductor light emitting element that generates blue light. As the red semiconductor light emitting element, the green semiconductor light emitting element, and the blue semiconductor light emitting element, for example, those using a nitride-based group III-V compound semiconductor can be used, and as the red semiconductor light emitting element, for example, those using an AlGaInP-based compound semiconductor can also be used. The semiconductor light emitting element may be an ultraviolet light emitting element in an invisible range (configured by a nitride-based group III-V compound semiconductor) or an infrared light emitting element (configured by AlGaAs and GaAs-based compound semiconductor) used for a motion sensor or the like.

The first compound semiconductor layer 10 is connected to an auxiliary electrode (not illustrated) around the outside of the light emitting element array 1 in the plane direction of the light emitting element array 1. The auxiliary electrode is an electrode common to the plurality of semiconductor light emitting elements 2. The auxiliary electrode may be configured by a material similar to the contact electrode 9 described later. The second compound semiconductor layer 11 is connected to the contact electrode 9.

### (Contact Electrode)

The contact electrode 9 is individually electrically connected to the second compound semiconductor layer 11 of each laminated structure 7. In the example of Fig. 1, the contact electrode 9 is provided immediately below the second compound semiconductor layer 11 (second main surface side).

Examples of the material of the contact electrode 9 include indium oxide, indium-tin oxide (ITO: Indium Tin Oxide, Sn-doped In₂O₃, crystalline ITO, and amorphous ITO are included), indium-zinc oxide (IZO), indium-gallium oxide (IGO), indium-doped gallium-zinc oxide (IGZO, In-GaZnO₄), IFO (F-doped In₂O₃, tin oxide (SnO₂), ATO (Sb-doped SnO2), FTO (F-doped SnO₂), zinc oxide (ZnO, Al-doped ZnO, B-doped ZnO, Ga-doped ZnO), antimony oxide, spinel type oxide, and oxide having a YbFe₂O₄ structure.

In addition, examples of the material of the contact electrode 9 include at least one metal (including an alloy) selected from the group including gold (Au), silver (Ag), palladium (Pd), platinum (Pt), nickel (Ni), Al (aluminum), Ti (titanium), tungsten (W), vanadium (V), chromium (Cr), Cu (copper), zinc (Zn), tin (Sn), germanium (Ge), and indium (In). Note that, in a case where the reflective metal layer 13 is provided, the contact electrode 9 may be omitted by configuring the reflective metal layer 13 to also serve as the contact electrode 9. Alternatively, the contact electrode 9 also functions as the reflective metal layer 13, so that the reflective metal layer 13 may be omitted.

### (Optical Adjustment Layer)

The light emitting element array 1 includes an optical adjustment layer 4 in each of the plurality of light emitting units 3. The optical adjustment layer 4 is specified as a layer having a periodic structure portion 5 described later in at least a part thereof.

The optical adjustment layer 4 may be provided on the light emitting surface 20 side of the semiconductor light emitting element 2, or may be provided on the surface side opposite to the light emitting surface 20 of the semiconductor light emitting element 2. In the example of Fig. 1, the optical adjustment layer 4 is provided on the light emitting surface 20 side of the semiconductor light emitting element 2. Note that the light emitting surface 20 side of the semiconductor light emitting element 2 indicates that the semiconductor light emitting element 2 is present at a position closer to the light emitting surface 20 than the light source portion (closer to the first main surface side than the light emitting layer 12 in the example of Fig. 1) with respect to the light source portion (the light emitting layer 12 in the example of Fig. 1) that generates light in the semiconductor light emitting element 2. In the example illustrated in Fig. 1, the optical adjustment layer 4 is integrated with the layer structure on the light emitting surface 20 side of the semiconductor light emitting element 2. That is, in the semiconductor light emitting element 2, the first compound semiconductor layer 10 is provided on the light emitting surface 20 side (first main surface side), and the first compound semiconductor layer 10 is included in the optical adjustment layer 4. Specifically, a first refractive index portion 50 described later that forms the optical adjustment layer 4 is the first compound semiconductor layer 10. In addition, the surface side opposite to the light emitting surface 20 of the semiconductor light emitting element 2 indicates the second main surface side of the light emitting layer 12 in the example of Fig. 1.

However, this does not restrict that the optical adjustment layer 4 is a layer different from the layer forming the semiconductor light emitting element 2. For example, the optical adjustment layer 4 may be separately laminated on the light emitting surface 20 side with respect to the semiconductor light emitting element 2. Specifically, for example, the optical adjustment layer 4 may be created to be formed as a single structure, and the single structure forming the optical adjustment layer 4 may be bonded onto the first compound semiconductor layer 10 of the semiconductor light emitting element 2. In addition, the optical adjustment layer 4 may be directly laminated on the first compound semiconductor layer 10 when the light emitting element array 1 is manufactured.

In the first embodiment, similarly to the first compound semiconductor layer 10 being a layer common to the plurality of light emitting units 3, the optical adjustment layer 4 is a layer common to the plurality of light emitting units 3. Since the optical adjustment layer 4 is a layer common to the plurality of light emitting units 3, it is not necessary to form the optical adjustment layer 4 for each light emitting unit 3, and it is easy to form the optical adjustment layer 4 even if each light emitting unit 3 is further miniaturized.

### (Periodic Structure Portion)

The periodic structure portion 5 is specified as a portion in which the refractive index periodically changes at least along the plane direction of the optical adjustment layer 4 in the optical adjustment layer 4.

### (Photonic Crystal Portion)

The periodic structure portion 5 has a structure in which a refractive index is periodically modulated in an optical cycle substantially equal to or less than a wavelength of light generated from the semiconductor light emitting element 2, and is a portion having a so-called photonic crystal (photonic crystal portion). Therefore, the optical adjustment layer 4 having the periodic structure portion 5 becomes a photonic crystal structure. However, the photonic crystal structure is defined as a structure having a photonic crystal portion in at least a part thereof. Examples of the photonic crystal structure include a film. However, this does not limit the photonic crystal structure to a film.

The range in which the periodic structure portion 5 is formed in the optical adjustment layer 4 is not particularly limited, but in the example illustrated in Fig. 1, the periodic structure portion 5 is formed in the optical adjustment layer 4 over the plurality of light emitting units 3 in plan view of the light emitting unit 3.

### (Structure of Periodic Structure Portion 5)

The periodic structure portion 5 of the optical adjustment layer 4 illustrated in the example of Fig. 1 has a structure in which the first refractive index portion 50 and the second refractive index portion 51 having different refractive indexes two-dimensionally in a plane direction (XY plane direction) are repeated at a predetermined interval. In the periodic structure portion 5, a portion corresponding to one cycle of the periodic change of the refractive index in the periodic structure portion 5 is repeatedly formed in the plane direction. In the examples of Figs. 1A and 1B, the unit structure portion 52 constituting the second refractive index portion 51 is arranged in the first refractive index portion 50 at predetermined intervals, so that a state in which the unit structure portion 52 and the first refractive index portion 50 are repeatedly arranged in the plane direction of the optical adjustment layer 4 is formed.

### (First Refractive Index Portion 50 and Second Refractive Index Portion 51)

In the examples of Figs. 1, 2A, and 2B, the first refractive index portion 50 is constituted by the first compound semiconductor layer 10 as described above. The second refractive index portion 51 is constituted by a plurality of unit structure portions 52 arranged in a two-dimensional layout in a plane direction of the optical adjustment layer 4. Each of the plurality of unit structure portions 52 is constituted by a columnar body 37. As a material of the columnar body 37, a material having a refractive index different from that of the first compound semiconductor layer 10 is selected.
In this example, the periodic structure portion 5 has a structure in which a plurality of columnar bodies 37 is two-dimensionally arranged in a layer (first compound semiconductor layer 10) forming the first refractive index portion 50. Note that this does not limit the structure of the periodic structure portion 5. In addition, in the example of Fig. 1, the unit structure portion 52 is formed from the first surface side of the first compound semiconductor layer 10 to a predetermined depth of the first compound semiconductor layer 10, and is formed in a state of not penetrating the first compound semiconductor layer 10. As a result, in the light emitting element array 1, it is easy to ensure the conductivity in the plane direction in the first compound semiconductor layer 10. However, this is not limited to the case where the unit structure portion 52 stays at the predetermined depth of the first compound semiconductor layer 10. The unit structure portion 52 may penetrate the first compound semiconductor layer 10. Furthermore, in the example of Fig. 1 and the like, one unit structure portion 52 is configured by one columnar body 37, but one unit structure portion 52 may be configured by a combination of a plurality of columnar bodies 37. For example, one unit structure portion 52 may be formed by combining a plurality of types of columnar bodies 37 having different sizes and refractive indexes.

### (Material of Second Refractive Index Portion)

The material of the second refractive index portion 51, that is, the material of the columnar body 37 in the example of Fig. 1 may be either an inorganic material or an organic material. Examples of the inorganic material include SiOx and SiN. Examples of the organic material include a silicon-based resin material, an acryl-based resin material, and a polyimide-based resin material.

The second refractive index portion 51 may be constituted by a single one of these materials, or may be constituted by a composite material. In addition, the second refractive index portion 51 may have a laminated structure in which layers constituted by these materials are laminated.

### (Periodicity of Periodic Structure Portion)

The periodicity of the periodic structure portion 5 may change. Note that the periodicity of the periodic structure portion 5 indicates regularity that defines periodic change of the refractive index in the periodic structure portion 5. The periodicity of the periodic structure portion 5 can be defined by, for example, a combination of a structure of the unit structure portion 52, which is a portion corresponding to a single cycle of a periodic change of the refractive index in the periodic structure portion 5, and a layout (repetition manner) of the unit structure portion 52.

In the examples of Figs. 1, 2A, 2B, 3, and the like, the periodicity of the periodic structure portion 5 changes. The periodic structure portion 5 includes a portion (first portion 5A) having a first periodicity and a portion (second portion 5B) having a second periodicity different from the first periodicity. In the example of Fig. 1 and the like, the first portion 5A corresponds to a portion corresponding to the first region R1 in the light emitting unit 3. In addition, the second portion 5B corresponds to a portion corresponding to the second region R2 in the light emitting unit 3.

Note that, in Fig. 1, the first region R1 and the second region R2 are defined according to the arrangement region RA of the light emitting layer 12 of the semiconductor light emitting element 2 in the light emitting unit 3 in plan view of the light emitting unit 3. The first region R1 in the light emitting unit 3 is defined as a predetermined region (a region wider than the arrangement region RA) that is the same as or includes the arrangement region RA in plan view of the light emitting unit 3. The second region R2 is defined to be the same as the portion excluding the arrangement region RA or a part of the portion excluding the arrangement region RA (a region narrower than the portion excluding the arrangement region RA) in plan view of the light emitting unit 3. In the example of Fig. 1, the second region R2 is a region excluding the first region R1, and the second region R2 is defined so as to surround the outer periphery of the first region R1 in plan view of the light emitting element array 1. In addition, in this example, the first region R1 and the second region R2 are divided in a state where the first region R1 and the second region R2 are in contact with each other at the boundaries.

In a case where the periodicity of the periodic structure portion 5 changes, the change in the periodicity may be realized by a structural difference or may be realized by a material difference. For example, in the example of Figs. 1 and 2B, the difference between the first periodicity and the second periodicity is realized by the structural difference between the first portion 5A and the second portion 5B. Specifically, the interval PW1 of the unit structure portion 52 arranged in the first portion 5A is different from the interval PW2 of the unit structure portion 52 arranged in the second portion 5B.

In addition, the difference between the first periodicity and the second periodicity may be realized by having a difference in material between the first portion 5A and the second portion 5B. For example, the material forming the unit structure portion 52 arranged in the first portion 5A and the material forming the unit structure portion 52 arranged in the second portion 5B may be materials having different refractive indexes. Note that the difference between the first periodicity and the second periodicity may be realized by having both the structural difference and the material difference between the first portion 5A and the second portion 5B.

### (Light Emission Control Unit)

Preferably, at least a part of the periodic structure portion 5 forms the light emission control unit 60. The light emission control unit 60 is a portion having a function of controlling a propagation direction of light generated from the semiconductor light emitting element 2. In the example of Fig. 1, the light emission control unit 60 has a function of roughly aligning light generated from the light emitting unit 3 with light along the thickness direction of the optical adjustment layer 4. In addition, in the example of Fig. 1, the first portion 5A having the first periodicity in the periodic structure portion 5 of the optical adjustment layer 4 forms the light emission control unit 60. In this case, the first periodicity is defined so as to exhibit a function as the light emission control unit 60. Furthermore, in the example of Fig. 1, the formation region of the light emission control unit 60 is defined as a region that is the same as or wider than the arrangement region RA.

### (Waveguide Control Unit)

Preferably, at least a part of the periodic structure portion 5 forms a waveguide suppression unit 61. The waveguide suppression unit 61 is a portion that suppresses a waveguide of light generated in the semiconductor light emitting element 2 and incident on the optical adjustment layer 4 (a waveguide along the plane direction of the optical adjustment layer 4). Similarly to the light emission control unit 60, the waveguide suppression unit 61 can also control the propagation direction of light generated from the semiconductor light emitting element 2. In the example of Fig. 1, the second portion 5B having the second periodicity in the periodic structure portion 5 is the waveguide suppression unit 61. In this case, the second periodicity is defined so as to exhibit the function as the waveguide suppression unit 61. Note that, in the example of Fig. 1, the waveguide suppression unit 61 and the light emission control unit 60 are separated, but the waveguide suppression unit 61 and the light emission control unit 60 may overlap as described later.

### (Periodicity of Periodic Structure Portion in Entire Light Emitting Element Array)

The periodicity of the periodic structure portion 5 in a plan view of the entire light emitting element array 1 is defined according to the arrangement pattern of the plurality of light emitting units 3. In the example illustrated in Fig. 2A and the like, the plurality of light emitting units 3 has an arrangement pattern in which the light emitting units 3 are repeatedly arranged in the X-axis direction and the Y-axis direction as the predetermined direction, that is, an arrangement pattern in which the light emitting units 3 are arranged in the X-axis direction and the Y-axis direction. The change in the periodicity of the periodic structure portion 5 is repeated in the X-axis direction and the Y-axis direction, which are the directions in which the light emitting units 3 are arranged.

In the light emitting element array 1 illustrated in Figs. 1, 2A, and the like, the periodicity of the second portions 5B of the adjacent light emitting units 3 is constant. As a result, in plan view of the entire light emitting element array 1, the periodicity of the periodic structure portion 5 is the first periodicity in the first portion 5A, and is the second periodicity outside the first portion 5A (boundary portion of the second portion 5B adjacent to the second portion 5B). In this case, as illustrated in Figs. 1, 2A, 2B, and 3, regarding the periodicity of the periodic structure portion 5 in a plan view of the entire light emitting element array 1, the first periodicity and the second periodicity are repeated in the X-axis direction and the Y-axis direction, which are the direction in which the light emitting units 3 are arranged, and the change in periodicity between the first periodicity and the second periodicity is repeated.

### (Low-Resistance Portion)

In the light emitting element array 1, as illustrated in the example of Fig. 1, a low-resistance portion 6 is preferably provided on the first main surface side of the first compound semiconductor layer 10. In the case of Fig. 1, the light emitting element array 1 is in a state in which the low-resistance portion 6 is laminated in a predetermined pattern on the first main surface side with respect to the optical adjustment layer 4. Furthermore, in the case of this example, the low-resistance portion 6 is provided to be electrically connected to the first refractive index portion of the optical adjustment layer 4. However, Fig. 1 is not limited to the case where the light emitting element array 1 according to the first embodiment includes the low-resistance portion 6. In the light emitting element array 1, the low-resistance portion 6 may be omitted.

The low-resistance portion 6 can suppress the surface resistance of the first compound semiconductor layer 10. From this viewpoint, the low-resistance portion 6 is preferably electrically parallel to the first compound semiconductor layer 10.

In the examples of Figs. 1 and 2, the low-resistance portion 6 is constituted by a metal layer 6A. In plan view of the light emitting unit 3, the metal layer 6A is formed on the peripheral edge of the light emitting unit 3. In Figs. 1 and 2A, the metal layer 6A extends in a band shape in the X-axis direction and the Y-axis direction along the contour of the light emitting unit 3. As illustrated in these examples, the metal layer 6A extends over the peripheral edge or boundary of the adjacent light emitting units 3. As illustrated in Fig. 2A, the metal layer 6A has a lattice-like layout as a whole of the light emitting element array 1.

### (Lens)

Furthermore, in the light emitting element array 1, the lens 8 may be provided on the first main surface side of the optical adjustment layer 4 (that is, the first main surface side of the first compound semiconductor layer 10). In a case where the low-resistance portion 6 is provided, the lens 8 is disposed closer to the first main surface side than the low-resistance portion 6 in a portion overlapping the low-resistance portion 6. In the example of Fig. 1, the lens 8 is provided in each light emitting unit 3. The lens 8 is preferably an on chip lends (OCL). However, the example of Fig. 1 is not limited to the case where the light emitting element array 1 includes the lens 8. In the light emitting element array 1, the lens 8 may be omitted.

In the example of Fig. 1, each lens 8 is formed in a convex shape having a curved surface convexly curved on the first main surface side, and is a so-called convex lens. Since the lens 8 is provided, it is easier to perform adjustment so that the light generated from each semiconductor light emitting element 2 is emitted from each light emitting unit 3. Since the light emitting element array 1 includes the lens 8, light utilization efficiency can be improved. Note that, in this example, the shape of the lens 8 is a hemispherical convex lens, but the shape of the lens 8 is not limited to this shape.

### (Reflective Metal Layer)

The reflective metal layer 13 is preferably provided on the surface side (second main surface side) away from the light emitting layer 12 with respect to the contact electrode 9. The reflective metal layer 13 contains, for example, at least one metal element selected from the group including gold (Au), platinum (Pt), nickel (Ni), copper (Cu), titanium (Ti), aluminum (Al), magnesium (Mg), rhodium (Rh), and silver (Ag). The reflective metal layer 13 may contain the at least one metal element described above as a constituent element of the alloy. Specific examples of the alloy include an aluminum alloy and a silver alloy. Since the reflective metal layer 13 is provided, even if light is emitted from the light emitting layer 12 to the contact electrode 9 side, the light can be reflected by the reflective metal layer 13, and the propagation direction of the light can be easily directed to the light emitting surface 20 side.

### (Light Emitting Element-Side Bump)

A bump (referred to as a light emitting element-side bump 14) connected to a bump (substrate-side bump 15) or the like of the drive substrate 19 described later is preferably provided on the second main surface side of each semiconductor light emitting element 2. In the example of Fig. 1, the light emitting element-side bump 14 is constituted by a metal layer laminated in a predetermined region on the second main surface side of the reflective metal layer 13. Examples of the material of the light emitting element-side bump 14 include solder, nickel, gold, silver, copper, tin, titanium, tungsten, and the like, an alloy containing these, a laminated film, and the like. In the example of Fig. 1, the size of the light emitting element-side bump 14 is smaller than the formation region of the reflective metal layer 13, but is not limited to this example, and may be the same as the formation region of the reflective metal layer 13 or may be formed in a region wider than the reflective metal layer 13. This similarly applies to the substrate-side bump 15 described later. In addition, although not illustrated, a via, a wiring, or the like may be formed between the reflective metal layer 13 and the light emitting element-side bump 14. Further, as illustrated in Fig. 1, the light emitting element-side bump 14 may be formed at a position immediately below the reflective metal layer 13, or may be formed at a position shifted in the plane direction (XY plane direction) of the reflective metal layer 13.

### (First Insulating Layer)

As illustrated in the example of Fig. 1, in the light emitting element array 1 according to the first embodiment, the first insulating layer 17 may be formed in a region excluding the formation region of the contact electrode 9 in plan view of the semiconductor light emitting element 2 on the second main surface side of the laminated structure 7 constituting the semiconductor light emitting element 2 and the second main surface side of the optical adjustment layer 4. Since the first insulating layer 17 is formed, it is easy to protect each layer forming the laminated structure 7 when the light emitting element array 1 is manufactured. As the first insulating layer 17, an inorganic film can be exemplified.

### (Second Insulating Layer)

As illustrated in the example of Fig. 1, the second insulating layer 18 may be provided in a space (gap space S) formed between the adjacent semiconductor light emitting elements 2. In the example of Fig. 1, the gap space S is a space portion between the reflective metal layer 13 and the substrate-side insulating layer 16 and between the first insulating layer 17 and the substrate-side insulating layer 16. The gap space S is filled with the second insulating layer 18. As the second insulating layer 18, an inorganic film, a laminate of a plurality of inorganic films, a thermosetting resin, or the like can be used.

### (Drive Substrate)

As illustrated in Fig. 1, the semiconductor light emitting element 2 may be provided with the drive substrate 19 having a drive circuit array (hereinafter, simply described as a drive circuit) on the second main surface side of the semiconductor light emitting element 2. The drive substrate 19 includes a substrate 19A on which a drive circuit is formed. The material of the substrate 19A can be similar to that of the element substrate described later. Examples of the drive circuit include a logic circuit and an analog circuit. The drive circuit forms, for example, a circuit that controls driving of each semiconductor light emitting element 2. The drive substrate 19 can individually control light emission from the light emitting surface 20 of the semiconductor light emitting element 2 by controlling driving of each semiconductor light emitting element 2.

### (Substrate-Side Bump)

On the surface of the drive substrate 19, a bump (substrate-side bump 15) on the drive substrate 19 side is provided on the surface side facing the semiconductor light emitting element 2. The substrate-side bump 15 is a connection terminal for electrically connecting the semiconductor light emitting element 2 and the drive circuit, and is provided individually for each light emitting element-side bump 14. Each of the substrate-side bumps 15 is bonded to the corresponding light emitting element-side bump of the semiconductor light emitting element 2. Thus, an electrical connection is formed between the drive substrate 19 and the semiconductor light emitting element 2. The material of the substrate-side bump 15 may be selected from materials similar to those mentioned for the light emitting element-side bump 14.

Note that, in the example of Fig. 1, the electrical connection between the drive substrate 19 and the semiconductor light emitting element 2 is formed by the bonding between the substrate-side bump 15 of the drive substrate 19 and the light emitting element-side bump 14 of the semiconductor light emitting element 2, but the electrical connection method between the drive substrate 19 and the semiconductor light emitting element 2 is not limited thereto. The connection method may be a bonding method in which a metal film is formed on the entire surface of each of the semiconductor light emitting element 2 and the drive substrate 19, the metal films are bonded to each other, and then the metal film is separated for each of the semiconductor light emitting element 2 and the light emitting unit 3, a method in which a build-up wiring is applied to the drive substrate 19 and the semiconductor light emitting element 2, or a method in which an LED is crystal-grown on the first surface of the drive substrate 19.

In addition, in the example of Fig. 1, there is one connection point between the drive substrate 19 and the semiconductor light emitting element 2, but the number of connection points may be two or more. For example, each of the first compound semiconductor layer 10 and the second compound semiconductor layer 11 in one semiconductor light emitting element 2 may be connected to the drive substrate 19.

### (Substrate-Side Insulating Layer)

The drive substrate 19 is provided with an insulating layer (substrate-side insulating layer 16) having a plurality of opening portions 16A on the first main surface side (surface side facing the semiconductor light emitting element 2). Each opening portion 16A is formed at a position of each substrate-side bump 15. At this time, the substrate-side bump 15 is exposed from the opening portion 16A. The substrate-side insulating layer 16 is configured by, for example, an organic material or an inorganic material. The organic material includes, for example, at least one of polyimide or acrylic resin. The inorganic material includes, for example, at least one of silicon oxide, silicon nitride, silicon oxynitride, or aluminum oxide.

### [1-2 Method for Manufacturing Light Emitting Element Array]

The light emitting element array according to the first embodiment can be manufactured by, for example, the following manufacturing method. Note that the description of the manufacturing method is made by exemplifying the method for manufacturing the light emitting element array 1 illustrated in Fig. 1.

### (Formation of Semiconductor Light Emitting Element)

An element substrate (not illustrated) is prepared. Examples of the material of the element substrate include sapphire and silicon. The first compound semiconductor layer 10, the light emitting layer 12, and the second compound semiconductor layer 11 are formed in this order on the surface of the element substrate. At this time, a laminated film to be the laminated structure 7 is formed. The formation and lamination of the first compound semiconductor layer 10, the light emitting layer 12, and the second compound semiconductor layer 11 can be performed by appropriately using, for example, a conventionally known crystal growth method of the semiconductor light emitting element 2.

Next, the element substrate is cut out to a size necessary for the light emitting element array as necessary, the element substrate is further removed, and the laminated structure of the first compound semiconductor layer 10, the light emitting layer 12, and the second compound semiconductor layer 11 is arranged on another substrate (referred to as a transfer substrate) different from the element substrate, and then the contact electrode 9 and the reflective metal layer 13 are formed on the surface of the second compound semiconductor layer 11. Then, the reflective metal layer 13, the contact electrode 9, the second compound semiconductor layer 11, and the light emitting layer 12 are etched according to the layout and shape of the semiconductor light emitting element 2. Further, a part of the first compound semiconductor layer 10 is etched. After the etching, the first insulating layer 17 and the second insulating layer 18 are sequentially formed in a predetermined pattern. At this time, in the second insulating layer 18, a portion corresponding to the light emitting element-side bump 14 is opened, and the reflective metal layer 13 is exposed. Then, the light emitting element-side bump 14 is laminated on the reflective metal layer 13.

### (Bonding of Semiconductor Light Emitting Element and Drive Substrate)

As the drive substrate 19 having the drive circuit, the substrate-side insulating layer 16 is formed on the substrate 19A, and the substrate-side bump 15 is formed at a position corresponding to the light emitting element-side bump 14 on the mobile substrate described above. The substrate 19A is arranged on the mobile substrate with the formation surface side of the substrate-side bump 15 of the substrate 19A facing the light emitting element-side bump 14 on the mobile substrate. Then, the substrate-side bump 15 and the light emitting element-side bump 14 are electrically bonded, and the substrate-side insulating layer 16 and the second insulating layer 18 are bonded. As a result, a bonding structure having a structure in which the semiconductor light emitting element 2 is bonded to the drive substrate 19 is formed. Then, the transfer substrate is peeled off from the bonding structure. In addition, if there is an unnecessary layer at this time, the unnecessary layer is also appropriately removed.

### (Formation of Optical Adjustment Layer)

The first compound semiconductor layer 10 is exposed on one surface (first main surface) of the bonding structure from which the mobile substrate has been peeled off. An etching mask is formed on the exposed surface side of the first compound semiconductor layer 10. The first compound semiconductor layer 10 is dry-etched to a predetermined depth. At this time, a hole portion corresponding to the unit structure portion 52 forming the second refractive index portion 51 is formed. The hole portion is formed in a predetermined size, a predetermined depth, and a predetermined shape according to the periodicity of the periodic structure portion 5 in the optical adjustment layer 4, and is formed at a predetermined position. Next, the hole portion is filled with a material having a refractive index different from that of the first refractive index portion 50. At this time, a material for forming the columnar body 37 is selected as a material having a refractive index different from that of the first refractive index portion 50. Examples of a method of filling this material include a chemical vapor deposition (CVD) method, a sputtering method, and a spin coating method.

In the step of filling the hole portion with the material for forming the columnar body 37, the surface of the first compound semiconductor layer 10, that is, the outside of the hole portion is covered with the layer of the material for forming the columnar body 37. Therefore, after this step, polishing is performed until the first compound semiconductor layer is exposed (polishing step). Through this polishing step, the surface of the bonding structure on the first main surface side becomes a polished surface. The polished surface is a flattened surface. In addition, the columnar body 37 is formed as the unit structure portion 52 by the material filled in each hole portion. As a result, the first refractive index portion 50 and the second refractive index portion 51 are formed, that is, the optical adjustment layer 4 is formed.

### (Formation of Low-Resistance Portion and the Like)

A metal layer 6A as the low-resistance portion 6 is laminated on the polished surface. The metal layer 6A is formed in a lattice shape along the contour of the light emitting unit 3. Then, a lens 8 is further formed for each light emitting unit 3. The lens 8 can be formed by appropriately using an on-chip-lens forming method. In this way, the light emitting element array 1 according to the first embodiment can be manufactured.

### [1-3 Functions and Effects]

In the light emitting element array 1 according to the first embodiment, as illustrated in Fig. 3, the optical adjustment layer 4 having the periodic structure portion 5 is formed. Fig. 3 is a cross-sectional view for explaining the functions and effects of the light emitting element array according to the first embodiment. Note that, in Fig. 3, for convenience of explanation, descriptions of the lens 8, the low-resistance portion 6, the first insulating layer 17, the second insulating layer 18, the light emitting element-side bump 14, the substrate-side bump 15, the substrate-side insulating layer 16, and the drive substrate 19 are omitted. In addition, in Fig. 3, the unit structure portion 52 is described to penetrate the first compound semiconductor layer 10.

In the light emitting element array 1, the periodic structure portion 5 of the optical adjustment layer 4 has a layer structure in which a plurality of columnar bodies 37 having a refractive index different from that of the first compound semiconductor layer 10 is formed in a predetermined arrangement in the first compound semiconductor layer 10. At this time, the first refractive index portion 50 is constituted by the first compound semiconductor layer 10, the unit structure portion 52 of the second refractive index portion 51 is constituted by the columnar body 37, and the unit structure portion 52 is repeatedly arranged. As illustrated in Fig. 3, the interval PW1 of the unit structure portion 52 of the first portion 5A and the interval PW2 of the unit structure portion 52 of the second portion 5B are equal to or less than an optical distance of about a wavelength of light generated from the semiconductor light emitting element 2, and the periodic structure portion 5 is a portion (photonic crystal portion) having photonic crystal in the first refractive index portion 50 and the second refractive index portion 51. The periodic structure portion 5 may have a first periodicity in the first portion 5A and a second periodicity in the second portion 5B, and the first portion 5A can be configured to correspond to the light emission control unit 60. The second portion 5B can be configured to correspond to the waveguide suppression unit 61.

Therefore, in the light emitting element array 1 according to the first embodiment, the optical adjustment layer 4 is formed, and the first periodicity can be defined such that the first portion 5A of the periodic structure portion 5 has a configuration corresponding to the light emission control unit 60. In this case, the light emitting direction from the light emitting layer 12 can be collected in the direction immediately above the light emitting layer 12 (+Z direction). As a result, the amount of light L1 traveling in the direction immediately above the light emitting layer 12 can be increased. Therefore, the luminance of the light emitting unit can be improved. In addition, it is possible to reduce the amount of power required for causing the light emitting unit to emit light at a target luminance, and to achieve low power consumption.

Furthermore, according to the first embodiment, the second periodicity can be defined such that the second portion 5B of the periodic structure portion 5 has a configuration corresponding to the waveguide suppression unit 61. As a result, the light L2 emitted from the light emitting layer 12 in the direction diffusing in the plane direction in the first compound semiconductor layer can be suppressed, and the generation of L1 can be further increased. In addition, it is also possible to suppress propagation of the light L2 from the second portion 5B to the adjacent light emitting unit 3. Therefore, according to the first embodiment, stray light can also be suppressed.

Next, a modification of the light emitting element array 1 according to the first embodiment will be described.

### [1-4 Modifications]

### (Modification 1)

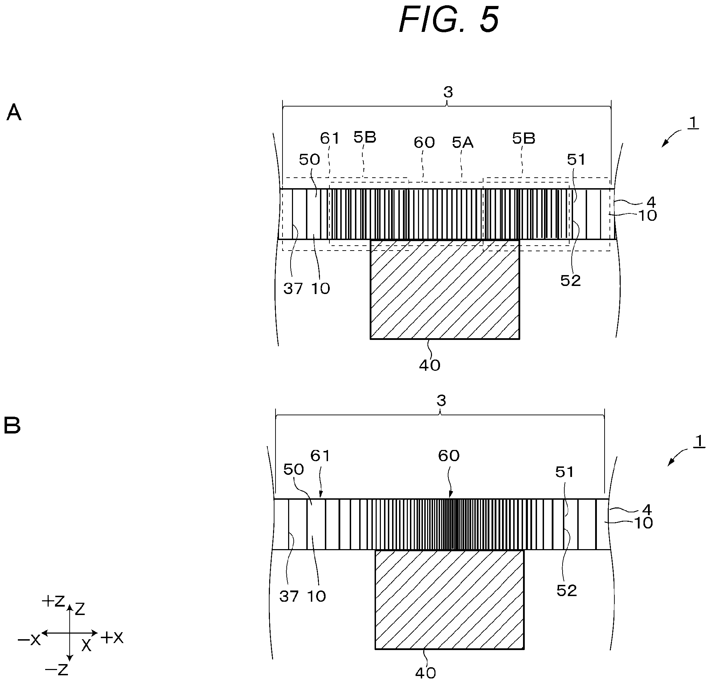

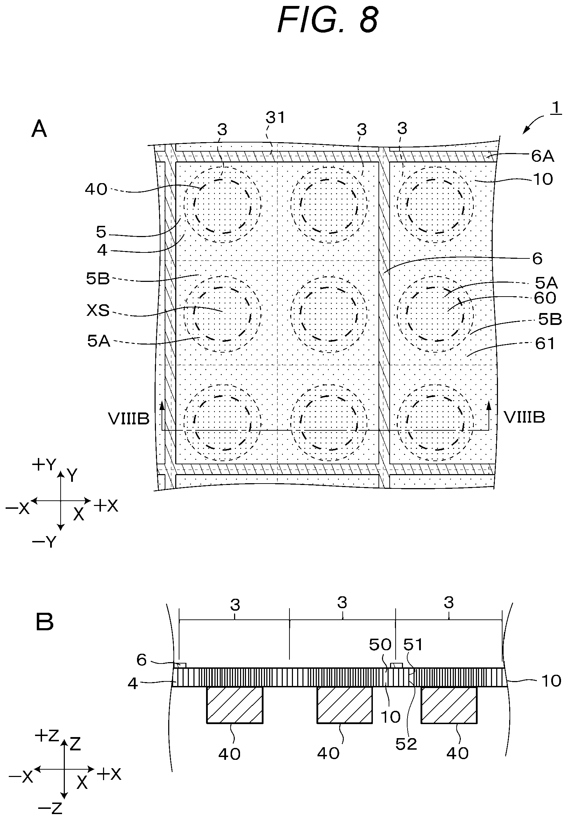

In the light emitting element array 1 according to the first embodiment, as illustrated in Figs. 4A, 4B, and 4C, the periodic structure portion 5 may be formed over the entire optical adjustment layer 4, and the periodicity of the periodic structure portion 5 may be constant (Modification 1). According to the light emitting element array 1 according to Modification 1 of the first embodiment, the formation of the optical adjustment layer 4 is facilitated. Figs. 4A and 4B are a plan view and a cross-sectional view, respectively, according to an example of a light emitting element array 1 according to Modification 1. Note that, in the examples of Figs. 4A and 4B, the low-resistance portion 6 is not illustrated in the light emitting element array 1 for convenience of description. In addition, in the examples of Figs. 5, 10, and 11, the description of the low-resistance portion 6 is similarly omitted for convenience of description. In addition, in Fig. 4A, the contour of the light emitting unit 3 is described by a broken line. This similarly applies to Fig. 8A.

### (Modification 2)

In the light emitting element array 1 according to the first embodiment, the periodicity of the periodic structure portion 5 may be formed such that only one of the light emission control unit 60 and the waveguide suppression unit 61 is formed in the optical adjustment layer 4 (Modification 2). For example, in the light emitting element array 1 according to the first embodiment, the first periodicity of the periodic structure portion 5 may be formed such that only the light emission control unit 60 is formed in the first portion 5A in the optical adjustment layer 4. Furthermore, in the light emitting element array 1 according to the first embodiment, the second periodicity of the periodic structure portion 5 may be formed such that only the waveguide suppression unit 61 is formed in the second portion 5B in the optical adjustment layer 4. According to the light emitting element array 1 of Modification 2, the formation of the optical adjustment layer 4 is facilitated.

### (Modification 3)

In the light emitting element array 1 according to the first embodiment, the first portion 5A and the second portion 5B may not be divided at the position of the boundary. For example, as illustrated in Fig. 5A, the first portion 5A and the second portion 5B may partially overlap (Modification 3). Fig. 5A is a cross-sectional view according to an example of a light emitting element array 1 according to Modification 3. In the light emitting element array 1 according to Modification 3 of the first embodiment illustrated in the example of Fig. 5A, in the periodic structure portion 5 of the optical adjustment layer 4, the unit structure portion 52 forming the first periodicity in the first portion 5A and the unit structure portion 52 forming the second periodicity in the second portion 5B are formed in the overlapping portion of the first portion 5A and the second portion 5B. According to the light emitting element array 1 of Modification 3, in a case where the first portion 5A functions as the light emission control unit 60 and the second portion 5B functions as the waveguide suppression unit 61, it is possible to expand the respective functional regions of the light emission control unit 60 and the waveguide suppression unit 61 while maintaining the area of the light emitting unit 3.

### (Modification 4)

In the light emitting element array 1 according to the first embodiment, an example in which the periodicity of the periodic structure portion 5 is two types of the first periodicity and the second periodicity has been described, but the present invention is not limited to this example. The periodicity of the periodic structure portion 5 may have three or more types.

### (Modification 5)

In the light emitting element array 1 according to the first embodiment, as illustrated in Fig. 5B, the periodicity of the periodic structure portion 5 may gradually change from a predetermined position corresponding to the first region R1 toward the second region R2 (gradation change). Fig. 5B is a cross-sectional view according to an example of a light emitting element array 1 according to Modification 5. In the light emitting element array 1 illustrated in the example of Fig. 5B, the periodic structure portion 5 has a structure in which periodicity at a predetermined position near the center of the light emitting unit 3 is made periodic so as to function as the light emission control unit 60, and periodicity is gradually changed to periodicity so as to function as the waveguide suppression unit 61 in a direction away from the center of the light emitting unit 3. This can be realized by adjusting the layout of the unit structure portion 52 as illustrated in Fig. 5B.

### (Modification 6)

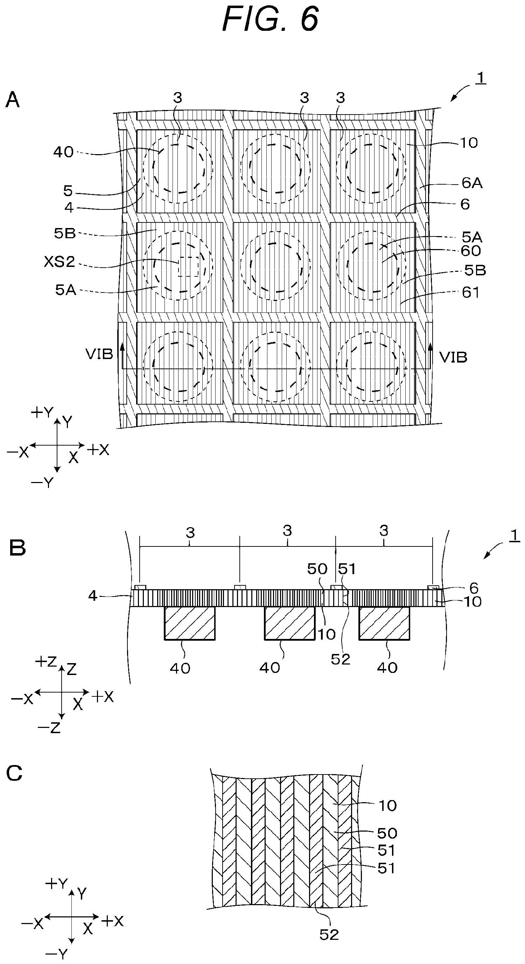

In the light emitting element array 1 according to the first embodiment, as illustrated in Figs. 6A, 6B, and 6C, the periodic structure portion 5 of the optical adjustment layer 4 may be configured such that the refractive index periodically changes along one direction. Figs. 6A and 6B are a plan view and a cross-sectional view, respectively, according to an example of a light emitting element array 1 according to Modification 6. Fig. 6C is a plan view schematically illustrating an enlarged state of a portion of region XS2 indicated by a broken line in Fig. 6A. In the case of Modification 6, the periodic structure portion 5 of the optical adjustment layer 4 is a structure portion whose refractive index periodically changes one-dimensionally. The periodic structure portion 5 of such an optical adjustment layer 4 can be specifically formed, for example, by arranging thin plate-shaped bodies extending in the Y-axis direction as the unit structure portions 52 in the first compound semiconductor layer 10 at intervals (intervals of about the wavelength of light) in the X-axis direction. Note that the material of the thin plate-shaped body may be constituted by a material similar to the columnar body 37 described in the first embodiment.

### (Modification 7)

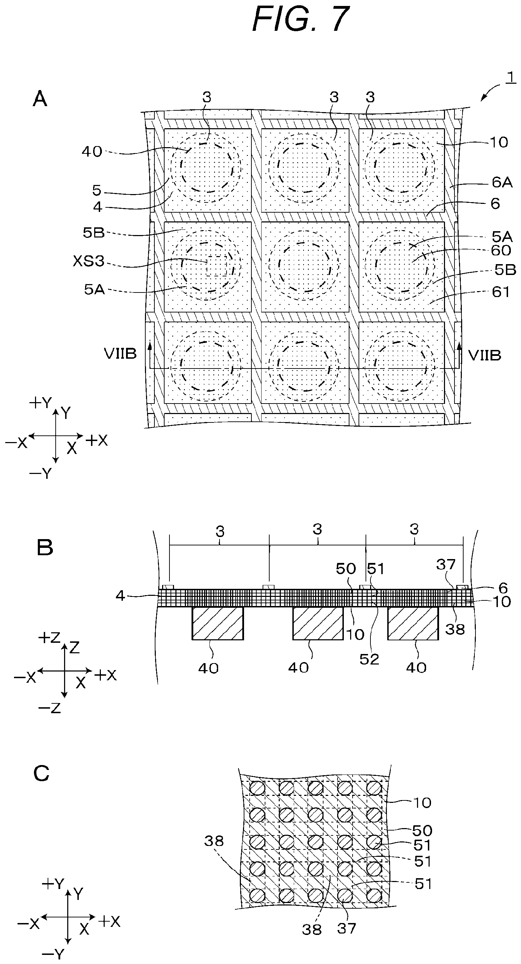

In the light emitting element array 1 according to the first embodiment, as illustrated in Figs. 7A, 7B, and 7C, the refractive index of the periodic structure portion 5 of the optical adjustment layer 4 may further periodically change along the thickness direction. Figs. 7A and 7B are a plan view and a cross-sectional view, respectively, according to an example of a light emitting element array 1 according to Modification 7. Fig. 7C is a plan view schematically illustrating an enlarged state of a portion of region XS3 indicated by a broken line in Fig. 7A. In Modification 7, the periodic structure portion 5 is a structure portion whose refractive index periodically changes three-dimensionally. In addition to the columnar bodies 37 described in the first embodiment, such optical adjustment layer 4 can be specifically formed by two-dimensionally arranging the columnar bodies 38 extending in the X-axis direction in the first compound semiconductor layer 10 at intervals (intervals of about the wavelength of light) in the YZ plane direction, and two-dimensionally arranging the columnar bodies 38 extending in the Y-axis direction at intervals (intervals of about the wavelength of light) in the XZ plane direction. Note that the material of the columnar body 38 extending in the X-axis direction and the Y-axis direction may be constituted by a material similar to the columnar body 37 described in the first embodiment. In Modification 6, the periodic structure portion 5 is a three-dimensional photonic crystal portion, and the optical adjustment layer 4 is a photonic crystal structure having a three-dimensional photonic crystal portion.

### (Modification 8)

In the light emitting element array 1 according to the first embodiment, in a case where the low-resistance portion 6 has a metal layer, the metal layer may be formed in a pattern along the peripheral edge of the light emitting unit group 31 as illustrated in Figs. 8A and 8B. Figs. 8A and 8B are respectively a plan view and a cross-sectional view for explaining an example of a light emitting element array 1 according to Modification 8 of the first embodiment. The light emitting unit group 31 is a portion including a plurality of adjacent light emitting units 3. Since the low-resistance portion 6 is formed in such a pattern, the amount of material used as the metal layer can be reduced as compared with a case where the low-resistance portion 6 is formed in a lattice-shaped pattern along the peripheral edge of each light emitting unit 3.

### (Modification 9)

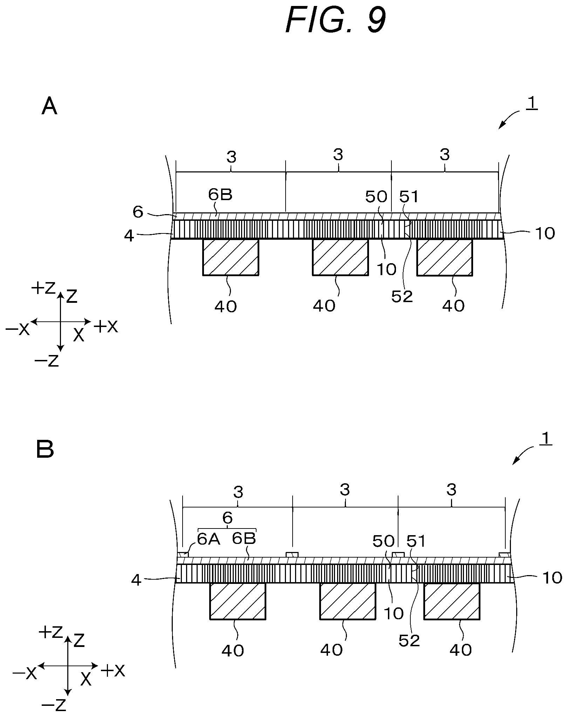

In the light emitting element array 1 according to the first embodiment, the low-resistance portion 6 may have a transparent electrode layer 6B as illustrated in Fig. 9A. Fig. 9A is a cross-sectional view schematically illustrating an example of a case where the low-resistance portion 6 includes the transparent electrode layer 6B. In a case where the low-resistance portion 6 has the transparent electrode layer 6B, the layout of the transparent electrode layer 6B is preferably formed in a layer so as to cover the surface of the optical adjustment layer 4 on the first main surface side (so as to cover the entire surface of the first compound semiconductor layer 10 on the first main surface side) from the viewpoint of efficiently suppressing the surface resistance.

As illustrated in Fig. 9B, the metal layer 6A and the transparent electrode layer 6B may be used in combination for the low-resistance portion 6. Fig. 9B is a cross-sectional view schematically illustrating an example in a case where the low-resistance portion 6 includes both the metal layer 6A and the transparent electrode layer 6B. Since the low-resistance portion 6 uses a plurality of layers in combination as described above, the effect of suppressing the surface resistance can be enhanced.

### (Modification 10)

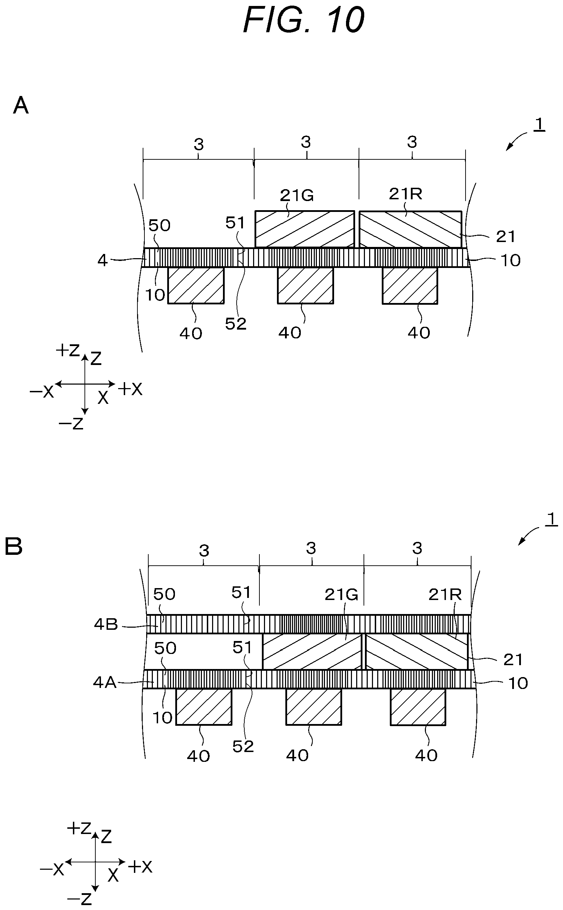

In the light emitting element array 1 according to the first embodiment, as illustrated in Fig. 10A, a color conversion layer may be provided (Modification 10). Fig. 10A is a diagram illustrating an example of a light emitting element array 1 according to Modification 10 of the first embodiment.

### (Color Conversion Layer)

Examples of the color conversion layer include a quantum dot layer 21. The quantum dot layer 21 is a layer including a plurality of quantum dots. Examples of the quantum dot include a quantum dot having a core portion constituted by a compound semiconductor and a shell layer covering a peripheral surface of the core portion and constituted by a semiconductor or the like. In the example of Fig. 10A, as the quantum dot layer 21, a green quantum dot layer 21G and a red quantum dot layer 21R are provided. In addition, in this example, as the semiconductor light emitting element 2, a blue semiconductor light emitting element that generates blue light is used for any of the light emitting unit 3 provided with the green quantum dot layer 21G, the light emitting unit 3 provided with the red quantum dot layer 21R, and the light emitting unit 3 provided with neither the green quantum dot layer 21G nor the red quantum dot layer 21R. Note that, in Fig. 10A, for convenience of explanation, the light emitting unit 3 in which neither the green quantum dot layer 21G nor the red quantum dot layer 21R is provided is provided with a layer that transmits light at a position corresponding to the quantum dot layer 21. However, in Fig. 10A, description of a layer that transmits light is omitted for convenience of description.

According to the light emitting element array 1 of Modification 10, the type of the emission color can be increased by providing the color conversion layer.

### (Modification 11)

In the light emitting element array 1 according to Modification 10 of the first embodiment, as illustrated in Fig. 10B, an optical adjustment layer may be further provided on the first main surface side of the color conversion layer (Modification 11). Fig. 10B is a diagram for explaining an example of a light emitting element array 1 of Modification 11. Note that, in Fig. 10B, the case where the color conversion layer is quantum dot layer 21 (green quantum dot layer 21G and red quantum dot layer 21 R) is described. In addition, in Fig. 10B, for convenience of explanation, description of the layer provided at the position corresponding to the quantum dot layer 21 is omitted for the light emitting unit 3 in which neither the green quantum dot layer 21G nor the red quantum dot layer 21R is provided.

In the light emitting element array 1 according to Modification 11, a first optical adjustment layer 4A and a second optical adjustment layer 4B are provided as the optical adjustment layer 4. The first optical adjustment layer 4A is provided on the semiconductor light emitting element 2 side (in Fig. 10B, the portion 40 side of the semiconductor light emitting element 2) with respect to the color conversion layer (quantum dot layer 21). In addition, the second optical adjustment layer 4B is provided on the quantum dot layer 21 (+Z direction side). The first optical adjustment layer 4A includes the periodic structure portion 5 as described above. In the example of Fig. 10B, as described in the first embodiment, in the periodic structure portion 5 of the first optical adjustment layer 4A, the first refractive index portion 50 is configured by the portion of the first compound semiconductor layer 10. The second refractive index portion 51 is constituted by the plurality of unit structure portions 52.

In addition, the second optical adjustment layer 4B has the periodic structure portion 5 similarly to the first optical adjustment layer 4A. However, the first refractive index portion 50 forming the periodic structure portion 5 of the second optical adjustment layer 4B may not be the first compound semiconductor layer 10 as long as the refractive index is different from that of the second refractive index portion 51.

The periodicity of the periodic structure portion 5 in the second optical adjustment layer 4B is periodicity corresponding to the content of the color conversion layer. In the example of Fig. 10B, the green quantum dot layer 21G and the red quantum dot layer 21R are provided as the color conversion layers, and the periodic structure portion 5 in the second optical adjustment layer 4B on the green quantum dot layer 21G has periodicity corresponding to green light. The periodic structure portion 5 in the second optical adjustment layer 4B on the red quantum dot layer 21R has periodicity corresponding to red light.

### (Modification 12)

In the light emitting element array 1 according to the first embodiment, as illustrated in Fig. 11, the light emitting unit 3 may include a plurality of sub light emitting units 30, and the optical adjustment layer 4 may include a periodic structure portion 5 corresponding to the plurality of sub light emitting units 30. The optical adjustment layer 4 is a layer common to the plurality of sub light emitting units 30 and also common to the plurality of light emitting units 3.

In the example of Fig. 11, the sub light emitting unit 30 includes a red light emitting unit 30R, a green light emitting unit 30G, and a blue light emitting unit 30B. The red light emitting unit 30R includes a red semiconductor light emitting element that generates red light as the semiconductor light emitting element 2. The green light emitting unit 30G includes a green semiconductor light emitting element that generates green light as the semiconductor light emitting element 2. The blue light emitting unit 30B includes a blue semiconductor light emitting element that generates blue light as the semiconductor light emitting element 2. The optical adjustment layer 4 has a periodic structure portion 5 in a portion corresponding to each of the red light emitting unit 30R, the green light emitting unit 30G, and the blue light emitting unit 30B. The periodicity of the periodic structure portion 5 and the size, depth, and shape of the columnar body 37 are defined according to the light generated from each of the red light emitting unit 30R, the green light emitting unit 30G, and the blue light emitting unit 30B.

In the example of Fig. 11, the red light emitting unit 30R, the green light emitting unit 30G, and the blue light emitting unit 30B are arranged in a delta-shaped layout, but in the light emitting element array 1 according to Modification 12, the arrangement of the sub light emitting units 30 is not limited to this example. The arrangement of the sub light emitting units 30 may be a square arrangement, a stripe arrangement, or the like. For example, in a case where the light emitting unit 3 is formed by four sub light emitting units 30 including the red light emitting unit 30R, the green light emitting unit 30G, and two blue light emitting units 30B, the square array indicates an array in which the center of each of the four sub light emitting units 30 is located at the vertex of the square. The stripe arrangement indicates an arrangement in which a plurality of types of the sub light emitting units 30 is arranged side by side.

In addition, at least a part of the red light emitting unit 30R, the green light emitting unit 30G, and the blue light emitting unit 30B may be provided with another light emitting element different from the semiconductor light emitting element.

### [2 Second Embodiment]

### [2-1 Configuration of Light Emitting Element Array]

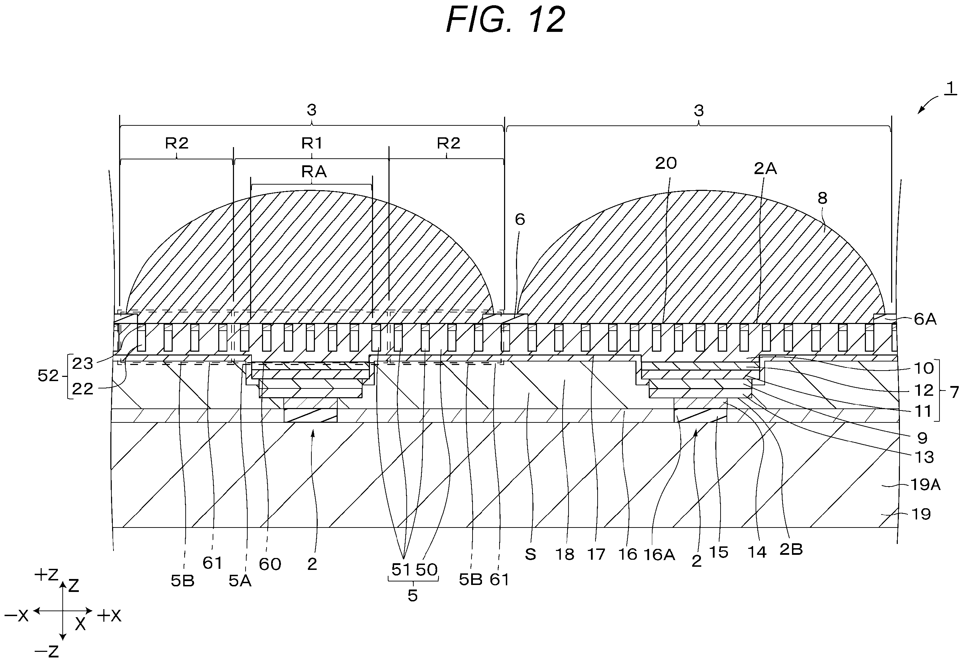

In the light emitting element array 1 according to the first embodiment, as illustrated in Fig. 12, the unit structure portion 52 in the second refractive index portion 51 constituting the optical adjustment layer 4 may include a space portion 22 and a plug portion 23 closing the space portion 22 (this is referred to as a second embodiment). Fig. 12 is a diagram illustrating an example of the light emitting element array 1 according to the second embodiment.

In the light emitting element array 1 according to the second embodiment, other configurations except for the configuration of the unit structure portion 52 may be configured similarly to the light emitting element array according to the first embodiment.

### (Space Portion)

In the example of Fig. 12, the space portion 22 forming the unit structure portion 52 is formed in a tubular shape at a position where desired periodicity of the periodic structure portion 5 can be realized.

### (Plug Portion)

The plug portion 23 has a predetermined thickness from the position of the first main surface (+Z direction) of the optical adjustment layer 4 toward the upper end edge (end edge on the +Z direction side) of the space portion 22. The material of the plug portion 23 may be constituted by a material similar to the columnar body 37 in the first embodiment.

### (Low-Resistance Portion)

In the light emitting element array 1 according to the second embodiment illustrated in Fig. 12, as described in the first embodiment, the low-resistance portion 6 is provided. The low-resistance portion 6 has a metal layer. Also in the low-resistance portion 6 of the second embodiment, as illustrated in Modification 9 of the first embodiment, the low-resistance portion 6 may have a laminated structure of a metal layer and a transparent electrode layer.

### [2-2. Method for Manufacturing Light Emitting Element Array]

A method for manufacturing the light emitting element array 1 according to the second embodiment will be described using the method for manufacturing the light emitting element array 1 illustrated in Fig. 12 as an example. As a method for manufacturing the light emitting element array 1 according to the second embodiment, a method similar to that of the light emitting element array according to the first embodiment is performed except that the upper end portion in the hole portion corresponding to the unit structure portion 52 forming the second refractive index portion 51 is filled with the material forming the plug portion 23 when the optical adjustment layer 4 is formed. It is possible to partially fill the material for forming the plug portion 23 on the upper end side of the hole portion by setting conditions when filling the hole portion with the material for partially forming the plug portion 23. The plug portion 23 and the space portion 22 are formed by partially filling the hole portion with the material for forming the plug portion 23.

As a method of partially filling the hole portion with the material for forming the plug portion 23, a method such as a CVD method, a sputtering method, and a spin coating method can be exemplified similarly to the case of forming the columnar body 37 in the method for manufacturing the light emitting element array 1 according to the first embodiment.

### [2-3 Functions and Effects]

According to the light emitting element array 1 according to the second embodiment, it is possible to realize functions and effects similar to those of the first embodiment. In addition, a structure in which the first compound semiconductor layer 10 and the space portion 22 are repeated can be formed in the periodic structure portion 5, and the refractive index difference between the first refractive index portion 50 formed by the first compound semiconductor layer 10 and the second refractive index portion 51 having the space portion 22 can be increased. In addition, since the upper end of the space portion 22 is closed by the plug portion 23, it is easy to perform a post-process such as formation of the lens 8 while maintaining the space portion 22 in the manufacturing process of the light emitting element array 1.

### [3 Third Embodiment]

### [3-1 Configuration of Light Emitting Element Array]

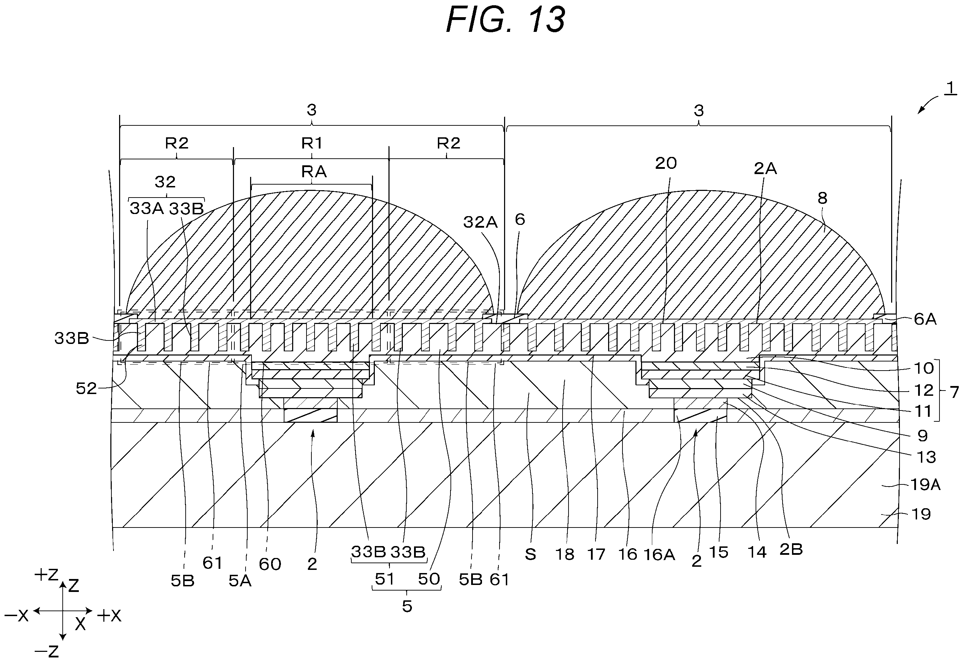

In the light emitting element array 1 according to the first embodiment or the second embodiment, as illustrated in Fig. 13, the optical adjustment layer 4 may be constituted by the covering layer 32 and the first compound semiconductor layer 10 (this is referred to as a third embodiment). Fig. 13 is a diagram illustrating an example of a light emitting element array 1 according to the third embodiment based on the first embodiment.

### (Covering Layer)

The covering layer 32 includes a covering portion 33A covering the first surface main side of the first refractive index portion 50 and a plurality of columnar portions 33B having the covering portion 33A as a base end.

### (Columnar Portion)

The columnar portion 33B may be formed similarly to the columnar body 37 in the light emitting element array 1 according to the first embodiment except that the covering portion 33A described later is used as a base end. That is, the columnar portion 33B is formed at a predetermined position of the first compound semiconductor layer 10. Each of the plurality of columnar portions 33B is the unit structure portion 52. The plurality of columnar portions 33B forms the second refractive index portion 51 constituting the periodic structure portion 5.

### (Covering Portion)

The covering portion 33A is constituted by a material similar to the columnar portion 33B, and is constituted integrally by the columnar portion 33B. The covering portion 33A covers a surface on the first main surface side of the first compound semiconductor layer 10 forming the first refractive index portion 50. In addition, in the example of Fig. 13, the covering portion 33A is formed in a pattern separated for each light emitting unit 3, and the opening portion 32A is formed along the contour of the light emitting unit 3. A part of the first compound semiconductor layer 10 is exposed from the opening portion 32A of the covering portion 33A.

### (Optical Adjustment Layer)

The optical adjustment layer 4 has a structure in which a plurality of columnar portions 33B is formed in the first compound semiconductor layer 10 and a structure in which the covering portion 33A covers the first compound semiconductor layer 10 and the plurality of columnar portions 33B. In the periodic structure portion 5 of the optical adjustment layer 4, the first refractive index portion 50 is constituted by the first compound semiconductor layer 10, and the second refractive index portion 51 is constituted by the plurality of columnar portions 33B.

### (Low-Resistance Portion)

In the light emitting element array 1 according to the third embodiment illustrated in Fig. 13, the low-resistance portion 6 is provided similarly to the first embodiment. The low-resistance portion 6 has a metal layer. The low-resistance portion 6 is formed so as to cover the opening portion 32A of the covering layer 32, and is electrically connected to the first compound semiconductor layer 10. However, this does not prohibit omission of the low-resistance portion 6 in the third embodiment. Also in the low-resistance portion 6 of the third embodiment, as illustrated in Modification 9 of the first embodiment, the low-resistance portion 6 may have a laminated structure of a metal layer and a transparent electrode layer.

### (Lens)

In a case where the light emitting element array 1 according to the third embodiment includes the lens 8, the covering portion 33A is interposed between the lens 8 and the periodic structure portion 5.

In the light emitting element array 1 according to the third embodiment, other configurations except for the configurations of the optical adjustment layer 4, the low-resistance portion 6, and the lens 8 described above may be configured similarly to the light emitting element array 1 according to the first embodiment.

### [3-2 Method for Manufacturing Light Emitting Element Array]

A method for manufacturing the light emitting element array 1 according to the third embodiment will be described by exemplifying the method for manufacturing the light emitting element array 1 illustrated in Fig. 13. The method for manufacturing the light emitting element array 1 according to the third embodiment is the same as the method for manufacturing the light emitting element array 1 according to the first embodiment until before the step of forming the optical adjustment layer 4.

In the step of performing the formation of the optical adjustment layer 4, when the hole portion is filled with the material forming the unit structure portion 52 (that is, when the hole portion is filled with the material forming the covering layer 32), the first compound semiconductor layer 10 is also coated with the material forming the unit structure portion 52. Thereafter, the polishing step of polishing until the first compound semiconductor layer 10 is exposed is omitted. However, the polishing step may be performed to such an extent that the first compound semiconductor layer is not exposed. Even in a case where the polishing step is omitted or not omitted, the state in which the first main surface side of the first refractive index portion 50 is covered with the material forming the unit structure portion 52 is maintained. Then, as described below, a low-resistance portion and the like are formed.

### (Formation of Low-Resistance Portion and the Like)

In a state where the first main surface side of the first refractive index portion 50 is covered with the material forming the unit structure portion 52, the opening portion 32A is patterned at a position corresponding to the low-resistance portion 6 (position between adjacent light emitting units 3). At this time, the first compound semiconductor layer 10 forming the first refractive index portion 50 is exposed from the opening portion 32A. Then, the metal layer 6A as the low-resistance portion 6 is laminated so as to cover the opening portion 32A. Then, similarly to the method for manufacturing the light emitting element array 1 according to the first embodiment, the lens 8 is further formed for each light emitting unit 3. Thus, the light emitting element array 1 according to the third embodiment can be manufactured.

### [3-3 Functions and Effects]

According to the light emitting element array 1 according to the third embodiment, it is possible to realize functions and effects similar to those of the first embodiment.

In the light emitting element array 1 according to the third embodiment, since the covering portion 33A is interposed between the lens 8 and the periodic structure portion 5, the photonic crystal portion formed in the periodic structure portion 5 and the lens 8 can be optically separated, and the effect of the periodic structure portion 5 as illustrated in the first embodiment can be enhanced.

### [4 Fourth Embodiment]

### [4-1 Configuration of Light Emitting Element Array]

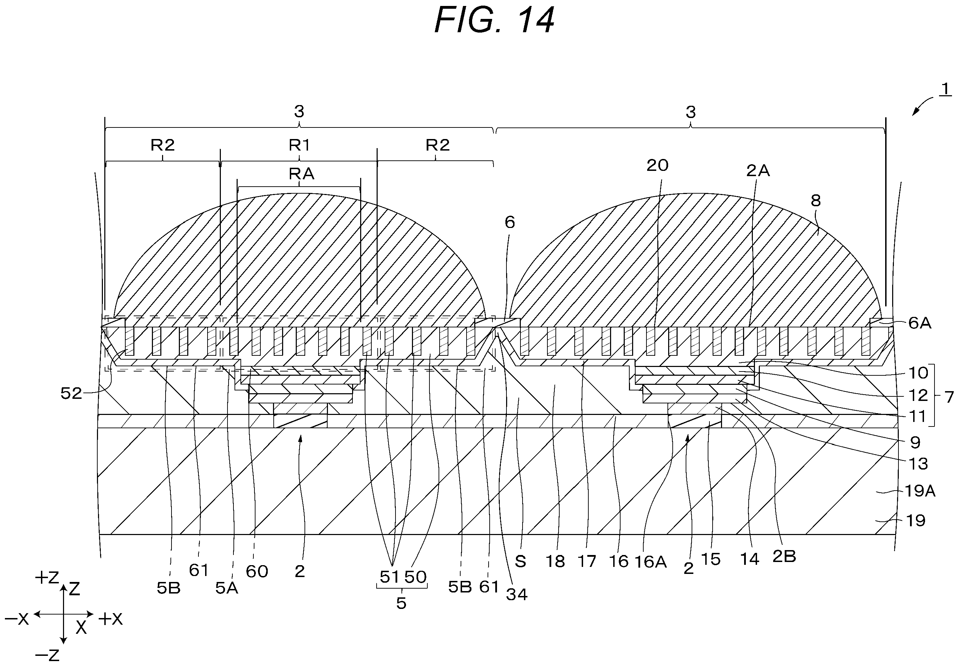

In the light emitting element array 1 according to the first to third embodiments, as illustrated in Fig. 14, the optical adjustment layer 4 may be separated for each light emitting unit 3 (this is referred to as a fourth embodiment). In this case, in the optical adjustment layer 4, a gap portion 34 is formed at a position between the adjacent light emitting units 3, and the first compound semiconductor layer 10 is separated for each light emitting unit 3. Fig. 14 is a diagram illustrating an example of a light emitting element array 1 according to the fourth embodiment based on the first embodiment.

In the light emitting element array 1 according to the fourth embodiment, other configurations except that the optical adjustment layer 4 is separated for each light emitting unit 3 (the first compound semiconductor layer 10 is separated for each light emitting unit 3) may be configured similarly to the light emitting element array 1 according to the first embodiment.

### (Gap Portion)

In the example of Fig. 14, the gap portion 34 is formed in a lattice shape in the optical adjustment layer 4 along the contour of the light emitting unit 3. As a result, the optical adjustment layer 4 is separated for each light emitting unit 3. In this case. The first compound semiconductor layer 10 is also divided at the position of the gap portion 34.

In the example of Fig. 14, the gap portion 34 is formed to have a tapered shape from the second main surface side toward the first main surface side (in the direction from the second compound semiconductor layer 11 toward the first compound semiconductor layer 10) (in the +Z direction along the Z-axis direction). However, this is an example, and the gap portion 34 may be formed to have a tapered shape from the first main surface side toward the second main surface side (in the direction from the first compound semiconductor layer 10 toward the second compound semiconductor layer 11) (in the -Z direction along the Z-axis direction).

### (Low-Resistance Portion)

In the light emitting element array 1 according to the fourth embodiment illustrated in Fig. 14, as described in the first embodiment, the low-resistance portion 6 is provided. The low-resistance portion 6 has a metal layer. The low-resistance portion 6 is located on the gap portion 34 and electrically connects the first compound semiconductor layer 10 divided between the adjacent light emitting units 3. Also in the low-resistance portion 6 of the fourth embodiment, as illustrated in Modification 9 of the first embodiment, the low-resistance portion 6 may have a laminated structure of a metal layer and a transparent electrode layer.

### [4-2. Method for Manufacturing Light Emitting Element Array]

A method for manufacturing the light emitting element array 1 according to the fourth embodiment will be described by exemplifying the method for manufacturing the light emitting element array 1 illustrated in Fig. 14. The method for manufacturing the light emitting element array 1 according to the fourth embodiment is performed, for example, as follows.

### (Formation of Semiconductor Light Emitting Element)

Similarly to the method for manufacturing the light emitting element array 1 according to the first embodiment, an element substrate is prepared, and the first compound semiconductor layer 10, the light emitting layer 12, and the second compound semiconductor layer 11 are laminated on the surface of the element substrate. The formation and lamination of the first compound semiconductor layer 10, the light emitting layer 12, and the second compound semiconductor layer 11 can be performed by appropriately using, for example, a conventionally known method of forming a mesa structure of a semiconductor light emitting element.

Next, the element substrate is cut out to a size necessary for the light emitting element array as necessary, the element substrate is further removed, and the laminated structure of the first compound semiconductor layer 10, the light emitting layer 12, and the second compound semiconductor layer 11 is arranged on a transfer substrate as another substrate different from the element substrate, and then the contact electrode 9 and the reflective metal layer 13 are formed on the surface of the second compound semiconductor layer. Then, the reflective metal layer 13, the contact electrode 9, the second compound semiconductor layer 11, and the light emitting layer 12 are etched according to the layout of the semiconductor light emitting element 2. In addition, a part of the first compound semiconductor layer 10 is etched. Up to this point, the method is similar to the method for manufacturing the light emitting element array 1 according to the first embodiment. In the method for manufacturing the light emitting element array 1 according to the third embodiment, the first compound semiconductor layer 10 is further etched according to the position of the gap portion 34. At this time, the first compound semiconductor layer 10 is divided to form the structure of the gap portion 34. For the subsequent steps, steps similar to those in the first embodiment are performed. As a result, the optical adjustment layer 4 is formed in a state of being separated by the gap portion 34. Thus, the light emitting element array 1 according to the fourth embodiment is obtained.

### [4-3 Functions and Effects]

According to the light emitting element array 1 according to the fourth embodiment, it is possible to realize functions and effects similar to those of the first embodiment.

In addition, since the first compound semiconductor layer 10 is separated for each light emitting unit 3, it is possible to more reliably prevent the light incident on the first compound semiconductor layer from traveling to the adjacent light emitting unit 3.

Furthermore, since the gap portion 34 has a tapered shape in the direction from the second compound semiconductor layer 11 toward the first compound semiconductor layer 10, an inclined surface is easily formed at the position of the gap portion 34 in the first compound semiconductor layer 10, and light incident in the first compound semiconductor layer is easily reflected by the inclined surface and emitted from the light emitting unit 3.

### [5 Fifth Embodiment]

### [5-1 Configuration of Light Emitting Element Array]

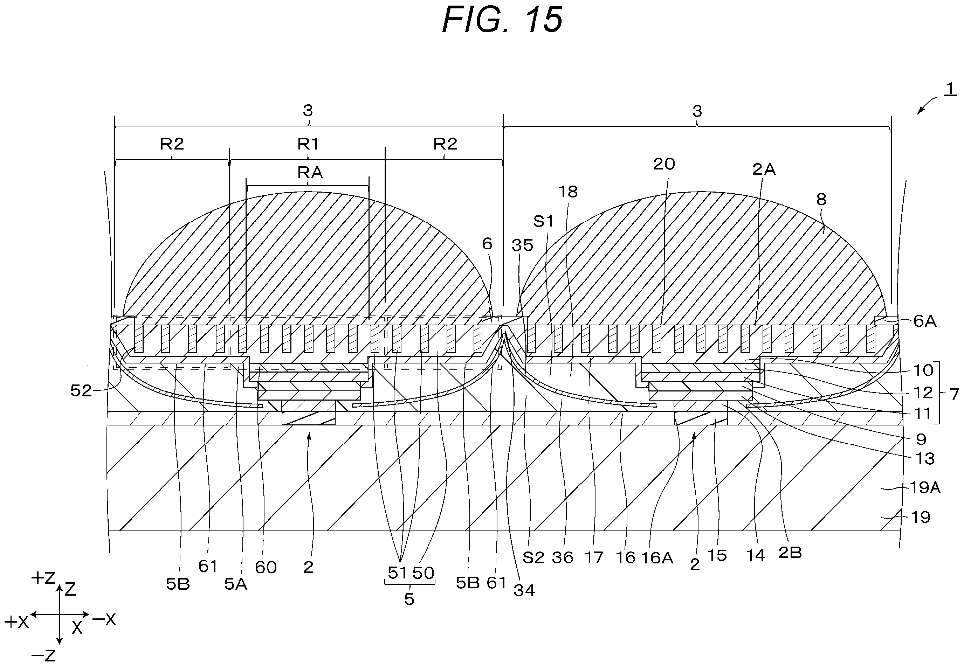

In the light emitting element array 1 according to the first to fourth embodiments, as illustrated in Fig. 15, a mirror 35 may be provided around the semiconductor light emitting element 2 (this is referred to as a fifth embodiment). In the example of Fig. 15, an example in a case where the mirror 35 is provided in the light emitting element array 1 according to the fourth embodiment is illustrated. In the example of the fifth embodiment illustrated in Fig. 15, in the gap space S between the adjacent semiconductor light emitting elements 2, the space on the first main surface side of the mirror 35 (space S1 on the surface side facing the semiconductor light emitting element 2) is filled with the second insulating layer 18, and the space on the second main surface side of the mirror (space S2 on the surface side opposite to the surface facing the semiconductor light emitting element 2) is filled with the third insulating layer 36.

In the light emitting element array 1 according to the fifth embodiment illustrated in the example of Fig. 15, other configurations except for the mirror 35, the second insulating layer 18, and the third insulating layer 36 may be configured similarly to the light emitting element array 1 according to the fourth embodiment.

### (Mirror)

In the example of Fig. 15, the mirror 35 is formed around each semiconductor light emitting element 2, and is formed in a concave curved shape in which a surface facing the semiconductor light emitting element 2 is a concave surface. The mirror 35 may be, for example, a metal layer having a property of reflecting light.

The example of Fig. 15 is an example, and the position and shape of the mirror 35 are not limited thereto. For example, the mirror 35 may be formed along a peripheral wall of the semiconductor light emitting element 2 (along an outer shape of semiconductor light emitting element 2). In a case where the mirror 35 is along the peripheral wall of the semiconductor light emitting element 2, the second insulating layer 18 on the first main surface side of the mirror 35 may be omitted, and only the third insulating layer 36 on the second main surface side of the mirror 35 may be formed. In addition, for example, the mirror 35 may be formed in a linear shape (non-curved surface shape) or may be formed in a parabolic surface shape.

Note that, in the example of Fig. 15, both the lens 8 and the mirror 35 are provided, but the lens 8 may be omitted in the fifth embodiment.

### (Second Insulating Layer)

The second insulating layer 18 is formed in the space S1 on the first main surface side of the mirror 35.

### (Third Insulating Layer)

In the example of Fig. 15, as described above, the space S2 on the second main surface side of the mirror 35 is filled with the third insulating layer 36. The material of the third insulating layer 36 may be selected from materials selectable as the material of the second insulating layer 18. In addition, the material of the third insulating layer 36 may be the same as the material of the second insulating layer 18.

### [5-2 Method for Manufacturing Light Emitting Element Array]

A method for manufacturing the light emitting element array 1 according to the fifth embodiment will be described by exemplifying the method for manufacturing the light emitting element array 1 illustrated in Fig. 15. The method for manufacturing the light emitting element array 1 according to the fifth embodiment is performed, for example, as follows.

### (Formation of Semiconductor Light Emitting Element)

Similarly to the method for manufacturing the light emitting element array according to the fourth embodiment, the first compound semiconductor layer 10, the light emitting layer 12, the second compound semiconductor layer 11, the contact electrode 9, and the reflective metal layer 13 are formed. Then, the reflective metal layer 13, the contact electrode 9, the second compound semiconductor layer 11, and the light emitting layer 12 are etched according to the layout of the semiconductor light emitting element 2. Further, a part of the first compound semiconductor layer 10 is etched, and the first compound semiconductor layer 10 is separated. Then, the first insulating layer 17 is formed. The steps up to this point are performed similarly to the method for manufacturing the light emitting element array according to the fourth embodiment.

Next, the second insulating layer 18 is formed, and the second insulating layer 18 is processed. The processing of the second insulating layer 18 can be realized by etching the second insulating layer 18 according to the shape of the first main surface side of the mirror 35. Thereafter, a metal layer for forming the mirror 35 is formed on the second insulating layer 18. Then, the third insulating layer 36 is formed. The method for forming the third insulating layer 36 may be similar to the method for forming the second insulating layer 18. As for the process after formation of the third insulating layer 36, as described in the fourth embodiment, a process similar to that of the first embodiment is performed. Thus, the light emitting element array according to the fifth embodiment is obtained.

### [5-3 Functions and Effects]

According to the light emitting element array 1 according to the fifth embodiment, it is possible to realize functions and effects similar to those of the first embodiment as described in the fourth embodiment. In addition, in the light emitting element array 1 according to the fifth embodiment, since the mirror 35 is provided, the luminance of the light emitting unit 3 can be improved. Furthermore, according to the light emitting element array 1 according to the fifth embodiment, since light emission to the drive substrate 19 side can be shielded, it is possible to prevent malfunction of the drive circuit provided on the drive substrate 19.

### [6 Application Example]

The light emitting element array 1 according to the above-described first to fifth embodiments and the modifications thereof can be applied to, for example, an apparatus, a device, a component, or the like that transmits and receives an optical signal. Specifically, the present invention can be used for a photocoupler, a light source for a drum photosensitive printer, a light source for a scanner, a light source for an optical fiber, a light source for an optical disk, an optical remote controller, a light measurement device, and the like. The number of light emitting elements provided in the light emitting element array mounted on the mounting substrate is one or more, and the number, type, mounting (arrangement), interval, and the like of the light emitting elements is only required to be determined according to specifications, applications, functions, and the like required for a device including the light emitting elements. Examples of the device obtained by mounting the light emitting element array 1 include a light emitting device in addition to the above device. Examples of the light emitting device include a headlight of a vehicle, an image display device, a backlight, a lighting device, and the like. A display device unit in a tiling type display device in which a plurality of display device units is arranged is also included in a device obtained by mounting a light emitting element array.

More specifically, the light emitting element array 1 according to the first to fifth embodiments and the modifications thereof described above can also be applied to various electronic devices. Specific examples of the electronic device include, but are not limited to, a personal computer, a mobile device, a mobile phone, a tablet computer, an imaging device, a game device, an industrial instrument, and a robot. A specific example of an electronic device to which the light emitting element array 1 is applied will be described below.

### (Specific Examples)

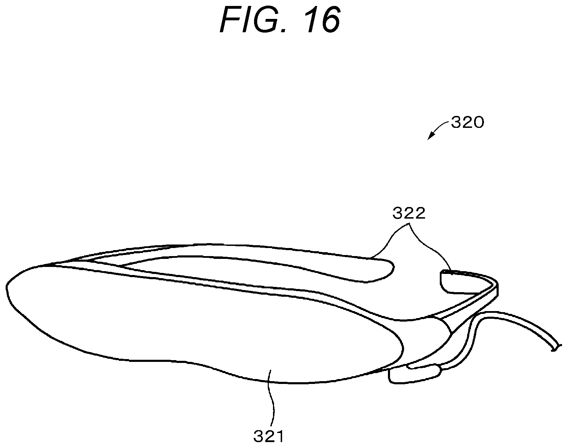

Fig. 16 illustrates an example of an external appearance of a head mounted display 320. The head mounted display 320 includes, for example, ear hooking portions 322 to be worn on the head of the user on both sides of a glass-shaped display unit 321. As the display unit 321, for example, a display device on which the light emitting element array 1 according to the above-described first to fifth embodiments and modifications thereof is mounted can be used. As a result, the head mounted display 320 can be, for example, VR glasses, AR glasses, or the like. By incorporating the light emitting element array 1 into the head mounted display 320, it is possible to obtain the head mounted display 320 in which stray light and power consumption are suppressed.

Although the embodiments of the present disclosure, the modifications thereof, and the examples of the manufacturing method thereof have been specifically described above, the present disclosure is not limited to the above-described embodiments, modifications thereof, and examples of the manufacturing method thereof, and various modifications based on the technical idea of the present disclosure can be made.

For example, the configurations, methods, steps, shapes, materials, numerical values, and the like mentioned in the above-described embodiments, modifications thereof, and examples of the manufacturing method thereof are merely examples, and different configurations, methods, steps, shapes, materials, numerical values, and the like may be used as necessary.

In addition, the configurations, methods, steps, shapes, materials, numerical values, and the like described in the above-described embodiments, modifications thereof, and examples of the manufacturing method thereof can be combined with each other without departing from the gist of the present disclosure.

The materials exemplified in the above-described embodiments can be used alone or in combination of two or more unless otherwise specified.

Note that the contents of the present disclosure are not to be construed as being limited by the effects exemplified in the present disclosure.

The present disclosure may have the following configurations.
(1) A light emitting element array including
   a plurality of a light emitting element including a light emitting surface,
   in which a plurality of a light emitting unit is formed including at least one of the light emitting element and capable of controlling light emission from the light emitting surface of the light emitting element, and
   the plurality of the light emitting unit is provided with an optical adjustment layer at least partially including a periodic structure portion in which a refractive index periodically changes.
(2) The light emitting element array according to (1),
   in which, in the periodic structure portion, periodicity defining a periodic change of the refractive index is changed.
(3) The light emitting element array according to (2),
   in which the plurality of the light emitting unit has an arrangement pattern repeatedly arranged in a predetermined direction, and
   a change in the periodicity is repeated according to the arrangement pattern.
(4) The light emitting element array according to any one of (1) to (3),
   in which the optical adjustment layer is a layer common to the plurality of the light emitting unit.
(5) The light emitting element array according to any one of (1) to (4),
   in which the optical adjustment layer is a cladding layer including at least one selected from a group including n-GaN, n-AlGaInP, and p-AlGaInP.
(6) The light emitting element array according to (5),
   in which a low-resistance portion is laminated on the optical adjustment layer.
(7) The light emitting element array according to (6),
   in which the low-resistance portion is electrically parallel to the optical adjustment layer.
(8) The light emitting element array according to (6) or (7),
   in which the low-resistance portion includes a metal layer, and
   in plan view of the light emitting unit, the metal layer is formed in a pattern along a peripheral edge of the light emitting unit or a peripheral edge of a light emitting unit group including the plurality of the light emitting unit adjacent.
(9) The light emitting element array according to any one of (6) to (8),
   in which the low-resistance portion includes a transparent electrode layer.
(10) The light emitting element array according to any one of (1) to (9),
   in which a drive substrate that controls light emission from the light emitting surface of the light emitting element is provided.
(11) The light emitting element array according to any one of (1) to (10),
   in which a color conversion layer that converts a light emission color from the light emitting surface of the light emitting element is further provided.
(12) The light emitting element array according to (11), further including
   a first optical adjustment layer and a second optical adjustment layer as the optical adjustment layer,
   in which the first optical adjustment layer is provided on a side of the light emitting element with respect to the color conversion layer, and
   the second optical adjustment layer is provided on the color conversion layer.
(13) The light emitting element array according to any one of (1) to (12),
   in which the periodic structure portion is a photonic crystal portion.
(14) The light emitting element array according to any one of (1) to (13),
   in which the refractive index of the periodic structure portion further periodically changes along a thickness direction.
(15) The light emitting element array according to any one of (1) to (14),
   in which the light emitting unit includes a plurality of sub light emitting units, and
   the optical adjustment layer includes the periodic structure portion corresponding to the plurality of sub light emitting units.
(16) The light emitting element array according to any one of (1) to (15),
   in which the periodic structure portion forms a light emission control unit that controls a propagation direction of light generated from the light emitting element.
(17) The light emitting element array according to any one of (1) to (16),
   in which the periodic structure portion forms a waveguide suppression unit that suppresses a waveguide of light generated in the light emitting element and incident on the optical adjustment layer.
(18) The light emitting element array according to any one of (1) to (17), in which, in the periodic structure portion, the refractive index periodically changes at least along a plane direction.
(19) The light emitting element array according to any one of (1) to (17),
   in which, in the optical adjustment layer, the refractive index of the periodic structure portion periodically changes one-dimensionally or twodimensionally along a plane direction of the optical adjustment layer.
(20) The light emitting element array according to any one of (1) to (19), in which the optical adjustment layer is provided on the light emitting surface side of the light emitting element.
(19) A photonic crystal structure
   used in a light emitting device, and
   including a photonic crystal portion in which a refractive index periodically changes at least along a plane direction in at least a part.
(20) A light emitting device
   using the light emitting element array according to any one of (1) to (17).
(21) An electronic device
   using the light emitting element array according to any one of (1) to (17).

### REFERENCE SIGNS LIST

- 1: Light emitting element array
- 2: Semiconductor light emitting element
- 3: Light emitting unit
- 4: Optical adjustment layer
- 5: Periodic structure portion
- 5A: First portion
- 5B: Second portion
- 6: Low-resistance portion
- 6A: Metal layer
- 6B: Transparent electrode layer
- 7: Laminated structure
- 8: Lens
- 9: Contact electrode
- 10: First compound semiconductor layer
- 11: Second compound semiconductor layer
- 12: Light emitting layer
- 13: Reflective metal layer
- 19: Drive substrate
- 20: Light emitting surface
- 22: Space portion
- 23: Plug portion
- 32: Covering layer
- 32A: Opening portion
- 33A: Covering portion
- 33B: Columnar portion
- 34: Gap portion
- 35: Mirror
- 36: Third insulating layer
- 37: Columnar body
- 40: Portion
- 50: First refractive index portion
- 51: Second refractive index portion
- 52: Unit structure portion
- 60: Light emission control unit
- 61: Waveguide suppression unit
- 320: Head mounted display
- 321: Display unit
- 322: Ear hooking portion

## Claims

1. A light emitting element array comprising
a plurality of a light emitting element including a light emitting surface,
wherein a plurality of a light emitting unit is formed including at least one of the light emitting element and capable of controlling light emission from the light emitting surface of the light emitting element, and
the plurality of the light emitting unit is provided with an optical adjustment layer at least partially including a periodic structure portion in which a refractive index periodically changes.

2. The light emitting element array according to claim 1,
wherein, in the periodic structure portion, periodicity defining a periodic change of the refractive index is changed.

3. The light emitting element array according to claim 2,
wherein the plurality of the light emitting unit has an arrangement pattern repeatedly arranged in a predetermined direction, and
a change in the periodicity is repeated according to the arrangement pattern.

4. The light emitting element array according to claim 1,
wherein the optical adjustment layer is a layer common to the plurality of the light emitting unit.

5. The light emitting element array according to claim 1,
wherein the optical adjustment layer is a cladding layer including at least one selected from a group including n-GaN, n-AlGaInP, and p-AlGaInP.

6. The light emitting element array according to claim 5,
wherein a low-resistance portion is laminated on the optical adjustment layer.

7. The light emitting element array according to claim 6,
wherein the low-resistance portion is electrically parallel to the optical adjustment layer.

8. The light emitting element array according to claim 6,
wherein the low-resistance portion includes a metal layer, and
in plan view of the light emitting unit, the metal layer is formed in a pattern along a peripheral edge of the light emitting unit or a peripheral edge of a light emitting unit group including the plurality of the light emitting unit adjacent.

9. The light emitting element array according to claim 6,
wherein the low-resistance portion includes a transparent electrode layer.

10. The light emitting element array according to claim 1,
wherein a drive substrate including a drive circuit array that controls light emission from the light emitting surface of the light emitting element is laminated.

11. The light emitting element array according to claim 1,
wherein a color conversion layer that converts a light emission color from the light emitting surface of the light emitting element is further provided.

12. The light emitting element array according to claim 11, further comprising
a first optical adjustment layer and a second optical adjustment layer as the optical adjustment layer,
wherein the first optical adjustment layer is provided on a side of the light emitting element with respect to the color conversion layer, and
the second optical adjustment layer is provided on the color conversion layer.

13. The light emitting element array according to claim 1,
wherein the periodic structure portion is a photonic crystal portion.

14. The light emitting element array according to claim 1,
wherein the refractive index of the periodic structure portion further periodically changes along a thickness direction.

15. The light emitting element array according to claim 1,
wherein the light emitting unit includes a plurality of sub light emitting units, and
the optical adjustment layer includes the periodic structure portion corresponding to the plurality of sub light emitting units.

16. The light emitting element array according to claim 1,
wherein the periodic structure portion forms a light emission control unit that controls a propagation direction of light generated from the light emitting element.

17. The light emitting element array according to claim 1,
wherein the periodic structure portion forms a waveguide suppression unit that controls a propagation direction of light generated from the light emitting element and suppresses a waveguide of light incident on the optical adjustment layer.

18. A photonic crystal structure
used in a light emitting device, and
including a photonic crystal portion in which a refractive index periodically changes at least along a plane direction in at least a part.

19. A light emitting device
using the light emitting element array according to claim 1.

20. An electronic device
using the light emitting element array according to claim 1.
